# EUROPEAN PATENT APPLICATION

(11) **EP 2 730 633 A1**
(43) Date of publication of application: **14.05.2014**
(21) Application number: 12191627.4
(22) Date of filing: 07.11.2012
(51) Int. Cl.: C09K 11/06, C08G 61/12, C08L 65/00, H01B 1/00, H01L 51/00, H01L 51/50

(54) **Polymer compound and its use in photovoltaic devices**

(71) Applicant: LANXESS Deutschland GmbH, 50569 Köln (DE); Institute of Problems of Chemical Physics of the Russian Academy of Sciences, Chernogolovka, Moscow Region 142432 (RU)
(72) Inventor: Khakina, Ekaterina A., Moscow Region, 142432 (RU); Akkuratov, Alexander V., Moscow Region 142432 (RU); Susarova, Diana K., Moscow Region 142432 (RU); Troshin, Pavel A., Moscow Region 142432 (RU); Razumov, Vladimir F., Moscow Region 142432 (RU)
(74) Representative: Wichmann, Birgid

(57) **Abstract**

The present invention relates to a polymer compound and a photovoltaic conversion device using the same having the general formula (I'): 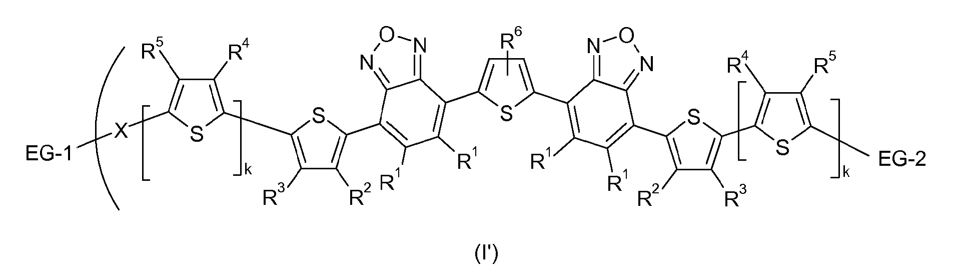 wherein R¹, R², R³, R⁴, R⁵, R⁶ are the same or mutually different and represent a hydrogen atom, a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a heterocyclic group, preferably a mono-valent heterocyclic group, a heterocyclic group with at least one sulphur atom, an amino group, a substituted amino group, a silyl group, a substituted silyl group, an acyl group, an acyloxy group, an imine group, an amide group, an acid imide group, a carboxyl group, a substituted carboxyl group, a cyano group or a nitro group, and
EG-1 and EG-2 are the end groups of the polymer compound and independent from each other are represented by hydrogen, halogen, trialkylstannyl (-Sn(Alkyl)₃), boronic acid (-B(OH)₂), boronic ester (-B(OAlkyl)₂) or an aryl unit,
X represents 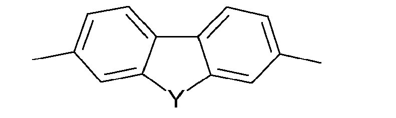 wherein Y = N-R⁷ or CR⁸R⁹,_{,}
k is a number of linearly linked thiophene units integrated in the repeating unit, preferably an integer from 0 to 3,
n is the number of repeating units, preferably from 2 to 2000
and R⁷, R⁸, R⁹ have the same meanings as R¹, R², R³, R⁴, R⁵ or R⁶.

## Description

The present invention relates to a polymer compound and a photovoltaic device using the same.

As materials used in organic film solar batteries, various polymer compounds are investigated, and a polymer compound containing as repeating units 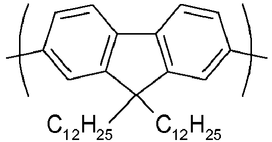 and 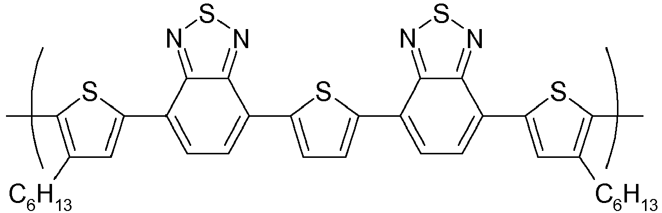 in a molar ratio of 50 : 50 is known as compound P4 from EP 2327734 A1.

However, an organic film solar battery fabricated by using the above-described polymer compound P4 provided insufficiently high photoelectric conversion efficiency (η) of just 0.94%.

The present invention has an object of providing a polymer compound affording an improved photoelectric conversion efficiency of 1% or more.

In a first aspect, the present invention provides a polymer compound comprising a repeating unit represented by the formula (I): 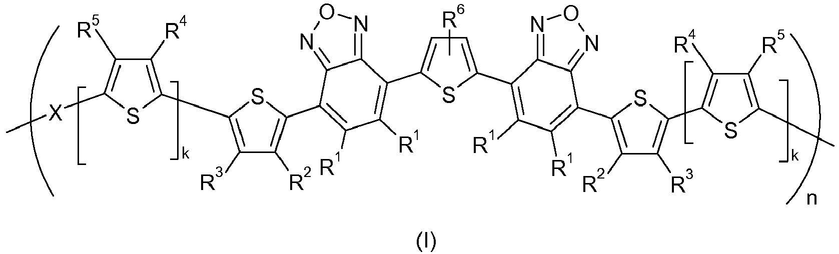 wherein R¹, R², R³, R⁴, R⁵, R⁶ are the same or mutually different and represent a hydrogen atom, a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a heterocyclic group, preferably a mono-valent heterocyclic group, a heterocyclic group with at least one sulphur atom, an amino group, a substituted amino group, a silyl group, a substituted silyl group, an acyl group, an acyloxy group, an imine group, an amide group, an acid imide group, a carboxyl group, a substituted carboxyl group, a cyano group or a nitro group, and
X represents 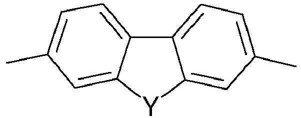 wherein Y = N-R⁷ or CR⁸R⁹,
k is a number of linearly linked thiophene units integrated in the repeating unit, preferably an integer from 1 to 3,
n is the number of repeating units, preferably from 2 to 2000,
and R⁷, R⁸, R⁹ have the same meanings as R¹, R², R³, R⁴, R⁵ or R⁶.

In another aspect, the present invention provides a photovoltaic device, preferably a photoelectric conversion device, having an anode, a cathode, and an organic layer containing at least one of the above-described polymer compounds disposed between the anode and the cathode.

A polymer compound comprising repeating units of formula (I) is represented by formula (I'): 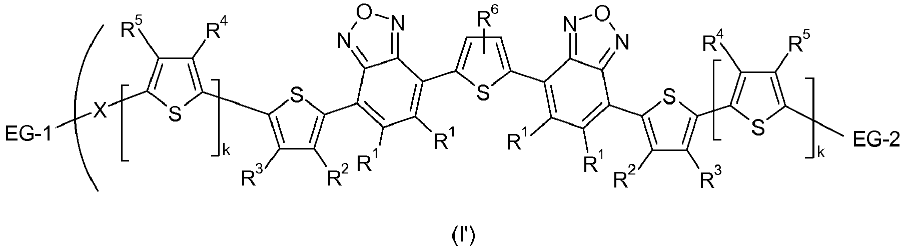 wherein in the repeating units R¹, R², R³, R⁴, R⁵, R⁶ are the same or mutually different and represent a hydrogen atom, a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a mono-valent heterocyclic group, a heterocyclic thio group, an amino group, a substituted amino group, a silyl group, a substituted silyl group, an acyl group, an acyloxy group, an imine residue, an amide group, an acid imide group, a carboxyl group, a substituted carboxyl group, a cyano group or a nitro group, and
X represents 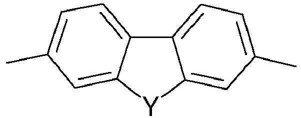 wherein Y = N-R⁷ or CR⁸R⁹,
k is a number of linearly linked thiophene units integrated in the repeating unit, preferably an integer from 0 to 3,
n is the number of repeating units, preferably from 2 to 2000,
R⁷, R⁸, R⁹ have the same meanings as R¹, R², R³, R⁴, R⁵ or R⁶,
EG-1 and EG-2 are the end groups of the polymer compound and independent from each other are represented by a hydrogen, a halogen, a trialkylstannyl (-Sn(Alkyl)₃), a boronic acid (-B(OH)₂), a boronic ester (-B(OAlkyl)₂), an aryl or a heteroaryl unit, preferably groups EG-1 and EG-2 of the polymer compound are represented by hydrogen, bromine or a phenyl unit.

The scope of the invention encompasses all of process steps, parameters and illustrations set forth above and below, either in general or within areas of preference or preferred embodiments, with one another, i.e., also any combinations between the particular areas and areas of preference.

In the context of the present invention the prefix "poly" is understood to mean that more than one identical or different repeating units of the general formula (I) are present in the polymer compound. The polymer compounds according to the present invention contain a total of n repeating units of the general formula (I) where n preferably is an integer from 2 to 2000, more preferred from 2 to 200. The repeating units of the general formula (I) may each be the same or different within a polymer compound according to the present invention. Preference is given to a polymer compound containing identical repeating units of the general formula (I) in each case

In the light of the foregoing, the present teachings provide certain polymeric compounds that can be used as organic semiconductor materials. Also provided are associated devices and related methods for the preparation and use of these compounds. The present compounds can exhibit properties such as optimized optical absorption, good charge transport characteristics and chemical stability in ambient conditions, low-temperature processability, large solubility in common solvents, and processing versatility (e.g. via various solution processes). As a result, optoelectronic devices, preferably solar cells, that incorporate one or more of the present compounds as a photoactive layer can exhibit high performance in ambient conditions, for example, demonstrating one or more of low band-gap, high fill factor, high open circuit voltage, and high power conversion efficiency, and preferably all of these criteria. Similarly, other organic semiconductor-based devices such as organic light emitting transistors (OLETs) can be fabricated efficiently using the organic semiconductor materials described herein.

The present invention also provides methods for preparing such polymer compounds and semiconductor materials, as well as various compositions, composites, and devices that incorporate the compounds and semiconductor materials disclosed herein.

The foregoing as well as other features and advantages of the present teachings will be more fully understood from the following figures, description, examples, and claims.

It should be understood that the drawings described below are for the illustration purposes only. The drawings are not necessarily to scale, with emphasis generally being placed upon illustrating the principles of the present teachings. The drawings are not intended to limit the scope of the present teachings in any way.

The present invention provides polymer compounds of formula (I') based upon at least one repeating unit that includes an electron-poor polycyclic heteroaryl group that is substituted with one or more electron-withdrawing groups.

Polymer compounds of the present invention can exhibit semiconductor behaviour such as optimized light absorption/charge separation in a photovoltaic device; charge transport/recombination/light emission in a light-emitting device; and/or high carrier mobility and/or good current modulation characteristics in a field-effect device. In addition, the polymer compounds of the present invention can posses certain processing advantages such as solution-processability and/or good stability (e.g. air stability) in ambient conditions. The polymer compounds of the present teachings can be used to prepare either p-type (donor or hole-transporting), n-type (acceptor or electron-transporting), or ambipolar semiconductor materials, which in turn can be used to fabricate various organic or hybrid optoelectronic articles, structures and devices, including organic photovoltaic devices and organic light-emitting transistors.

Throughout the application, where compositions are described as having, including, or comprising specific components, or where processes are described as having, including, or comprising specific process steps, it is contemplated that compositions of the present teachings also consist essentially of, or consist of, the recited components, and that the processes of the present teachings also consist of, the recited process steps.

In the application, where an element or component is said to be included in and/or selected from a list of recited elements or components, it should be understood that the element or component can be any one of the recited elements or components, or the element or component can be selected from a group consisting of two or more of the recited elements or components. Further, it should be understood that elements and/or features of a composition, an apparatus, or a method described herein can be combined in a variety of ways without departing from the spirit and scope of the present teachings, whether explicit or implicit herein.

The use of the terms "include", "includes", "including", "have", "has", or "having" should be generally understood as open-ended and non-limiting unless specifically stated otherwise.

The use of the singular herein includes the plural (and vice versa) unless specifically stated otherwise. In addition, where the use of the term "about" is before a quantitative value, the present teachings also include the specific quantitative value itself, unless specifically stated otherwise. As used herein, the term "about" refers to ± 10% variation from the nominal value unless otherwise indicated or inferred.

It should be understood that the order of steps or order for performing certain actions is immaterial so long as the present teachings remain operable. Moreover, two or more steps or actions may be conducted simultaneously.

As used herein, a "p-type semiconductor material" or a "donor" material refers to a semiconductor material, for example, an organic semiconductor material, having holes as the majority current or charge carriers. In some embodiments, when a p-type semiconductor material is deposited on a substrate, it can provide a hole mobility in excess of about 10⁻⁵ cm²/Vs. In the case of field-effect devices, a p-type semiconductor also can exhibit a current on/off ratio of greater than about 10.

As used herein, an "n-type semiconductor material" or an "acceptor" material refers to a semiconductor material, for example, an organic semiconductor material, having electrons as the majority current or charge carriers. In some embodiments, when an n-type semiconductor material is deposited on a substrate, it can provide an electron mobility in excess of about 10⁻⁵ cm²/Vs. In the case of field-effect devices, an n-type semiconductor also can exhibit a current on/off ratio of greater than about 10.

As used herein, "mobility" refers to a measure of the velocity with which charge carriers, for example, holes (or units of positive charge) in the case of a p-type semiconductor material and electrons (or units of negative charge) in the case of an n-type semiconductor material, move through the material under the influence of an electric field. This parameter, which depends on the device architecture, can be measured using a field-effect device or space-charge limited current measurements or some other techniques like transient photocurrent measurenets, CELIV (current extracted by linearly increased voltage) measurements.

As used herein, the power conversion efficiency (PCE) of a solar cell is the percentage of power converted from absorbed light to electrical energy. The PCE of a solar cell can be calculated by dividing the maximum power point (Pₘ) by the input light irradiance (E, in w/m2) under standard test conditions (STC) and the surface area of the solar cell (A_{c}, in m²). STC typically refers to a temperature of 25°C and an irradiance of 1000 w/m² with an air mass 1.5 (AM 1.5) spectrum.

As used herein, a component (such as a thin film layer) can be considered "photoactive" if it contains one or more compounds that can absorb photons to produce excitons for the generation of a photocurrent.

As used herein, "solution-processible" refers to compounds, preferably polymers, materials, or compositions that can be used in various solution-phase processes including spin-coating, printing, preferably inkjet printing, gravure printing, offset printing and the like, spray coating, electrospray coating, drop casting, dip coating, and blade coating.

As used herein, a "polymeric compound (or "polymer") refers to a molecule including a plurality of one or more repeating units connected by covalent chemical bonds. A polymeric compound can be represented by the general formula:

*(̵M)̵*

wherein M is the repeating unit or monomer. The polymeric compound can have only one type of repeating unit as well as two or more types of different repeating units. When a polymeric compound has only one type of repeating unit, it can be referred to as a homopolymer. When a polymeric compound has two or more types of different repeating units, the term "copolymer" or "copolymeric compound can be used instead. For example, a copolymeric compound can include repeating units

*(̵M^{a})̵* and *(̵M^{b})̵*,

where M^{a} and M^{b} represent two different repeating units. Unless specified otherwise, the assembly of the repeating units in the copolymer can be head-to-tail, head-to-head, or tail-to-tail. In addition, unless specified otherwise, the copolymer can be a random copolymer, an alternating copolymer, or a block copolymer. For example, the general formula:

*(̵M^{a}ₓ-M^{b}_{y})̵*

can be used to represent a copolymer of M^{a} and M^{b} having x mole fraction of M^{a} and y mole fraction of M^{b} in the copolymer, where the manner in which comonomers M^{a} and M^{b} is repeated can be alternating, random, regiorandom, regioregular, or in blocks. In addition to its composition, a polymeric compound can be further characterized by its degree of polymerization (n) and molar mass (e.g., number average molecular weight (Mₙ) and/or weight average molecular weight (M_{w}) depending on the measuring technique(s)).

As used herein, "halo" or "halogen" refers to fluoro, chloro, bromo, and iodo.

As used herein, "oxo" refers to a double-bonded oxygen (i.e., =O).

As used herein, "alkyl" refers to a straight-chain or branched saturated hydrocarbon group. Preferred alkyl groups include methyl (Me), ethyl (Et), propyl (e.g., n-propyl and iso-propyl), butyl (e.g., n-butyl, iso-butyl, sec-butyl, tert-butyl), pentyl groups (e.g., n-pentyl, iso-pentyl, neo-pentyl), hexyl groups, and the like. In various embodiments, an alkyl group can have 1 to 40 carbon atoms (i.e., C₁₋₄₀ alkyl group), for example, 1-20 carbon atoms (i.e., C₁₋₂₀ alkyl group). In some embodiments, an alkyl group can have 1 to 6 carbon atoms, and can be referred to as a "lower alkyl group." Examples of lower alkyl groups include methyl, ethyl, propyl (e.g., n-propyl and iso-propyl), and butyl groups (e.g., n-butyl, iso-butyl, secbutyl, tert-butyl). In some embodiments, alkyl groups can be substituted as described herein. An alkyl group is generally not substituted with another alkyl group, an alkenyl group, or an alkynyl group.

As used herein, "haloalkyl" refers to an alkyl group having one or more halogen substituents. At various embodiments, a haloalkyl group can have 1 to 40 carbon atoms (i.e., C₁₋₄₀ haloalkyl group), for example, 1 to 20 carbon atoms (i.e., C₁₋₂₀ haloalkyl group). Preferred haloalkyl groups include CF₃, C₂F₅, CHF₂, CH₂F, CCl₃, CHCl₂, CH₂Cl, C₂Cl₅, and the like. Perhaloalkyl groups, i.e., alkyl groups where all of the hydrogen atoms are replaced with halogen atoms (e.g., CF₃ and C₂F₅), are included within the definition of "haloalkyl." For example, a C₁₋₄₀ haloalkyl group can have the formula -CₛH₂ₛ₊₁₋ₜX⁰ₜ, where X⁰, at each occurrence, is F, Cl, Br or I, "s" is an integer in the range of 1 to 40, and "t" is an integer in the range of 1 to 81, provided that t is less than or equal to 2s+1. Haloalkyl groups that are not perhaloalkyl groups can be substituted as described herein.

As used herein, "alkoxy" refers to an -O-alkyl group. Preferred alkoxy groups include, but are not limited to, methoxy, ethoxy, propoxy (e.g., n-propoxy and isopropoxy), t-butoxy, pentoxyl, hexoxyl groups, and the like. The alkyl group in the -O-alkyl group can be substituted as described herein.

As used herein, "alkylthio" refers to an -S-alkyl group. Preferred alkylthio groups include, but are not limited to, methylthio, ethylthio, propylthio (e.g., n-propylthio and isopropylthio), t-butylthio, pentylthio, hexylthio groups, and the like. The alkyl group in the -S-alkyl group can be substituted as described herein.

As used herein, "alkenyl" refers to a straight-chain or branched alkyl group having one or more carbon-carbon double bonds. Preferred alkenyl groups include ethenyl, propenyl, butenyl, pentenyl, hexenyl, butadienyl, pentadienyl, hexadienyl groups, and the like. The one or more carbon-carbon double bonds can be internal (such as in 2-butene) or terminal (such as in 1-butene). In various embodiments, an alkenyl group can have 2 to 40 carbon atoms (i.e., C₂₋₄₀ alkenyl group), for example, 2 to 20 carbon atoms (i.e., C₂₋₂₀ alkenyl group). In some embodiments, alkenyl groups can be substituted as described herein. An alkenyl group is generally not substituted with another alkenyl group, an alkyl group, or an alkynyl group.

As used herein, "alkynyl" refers to a straight-chain or branched alkyl group having one or more triple carbon-carbon bonds. Preferred alkynyl groups include ethynyl, propynyl, butynyl, pentynyl, hexynyl, and the like. The one or more triple carbon-carbon bonds can be internal (such as in 2-butyne) or terminal (such as in 1-butyne). In various embodiments, an alkynyl group can have 2 to 40 carbon atoms (i.e., C₂₋₄₀ alkynyl group), for example, 2 to 20 carbon atoms (i.e., C₂₋₂₀ alkynyl group). In some embodiments, alkynyl groups can be substituted as described herein. An alkynyl group is generally not substituted with another alkynyl group, an alkyl group, or an alkenyl group.

As used herein, a "cyclic moiety" can include one or more (e.g., 1-6) carbocyclic or heterocyclic rings. The cyclic moiety can be a cycloalkyl group, a heterocycloalkyl group, an aryl group, or a heteroaryl group (i.e., can include only saturated bonds, or can include one or more unsaturated bonds regardless of aromaticity), each including, for example, 3-24 ring atoms and optionally can be substituted as described herein. In embodiments where the cyclic moiety is a "monocyclic moiety," the "monocyclic moiety" can include a 3-14 membered aromatic or non-aromatic, carbocyclic or heterocyclic ring. A monocyclic moiety can include, for example, a phenyl group or a 5- or 6-membered heteroaryl group, each of which optionally can be substituted as described herein. In embodiments where the cyclic moiety is a "polycyclic moiety," the "polycyclic moiety" can include two or more rings fused to each other (i.e., sharing a common bond) and/or connected to each other via a spiro atom, or one or more bridged atoms. A polycyclic moiety can include an 8-24 membered aromatic or non-aromatic, carbocyclic or heterocyclic ring, such as a C₈₋₂₄ aryl group or an 8-24 membered heteroaryl group, each of which optionally can be substituted as described herein.

As used herein, "cycloalkyl" refers to a non-aromatic carbocyclic group including cyclized alkyl, alkenyl, and alkynyl groups. In various embodiments, a cycloalkyl group can have 3 to 24 carbon atoms, for example, 3 to 20 carbon atoms (e.g., C₃₋₁₄ cycloalkyl group). A cycloalkyl group can be monocyclic (e.g., cyclohexyl) or polycyclic (e.g., containing fused, bridged, and/or spiro ring systems), where the carbon atoms are located inside or outside of the ring system. Any suitable ring position of the cycloalkyl group can be covalently linked to the defined chemical structure. Examples of cycloalkyl groups include cyclopropyl, cyclobutyl, cyclopentyl, cyclohexyl, cycloheptyl, cyclopentenyl, cyclohexenyl, cyclohexadienyl, cycloheptatrienyl, norbornyl, norpinyl, norcaryl, adamantyl, and spiro[4.5]decanyl groups, as well as their homologs, isomers, and the like. In some embodiments, cycloalkyl groups can be substituted as described herein.

As used herein, "heteroatom" refers to an atom of any element other than carbon or hydrogen and includes, for example, nitrogen, oxygen, silicon, sulfur, phosphorus, and selenium.

As used herein, "cycloheteroalkyl" refers to a non-aromatic cycloalkyl group that contains at least one ring heteroatom selected from O, S, Se, N, P, and Si (e.g., O, S, and N), and optionally contains one or more double or triple bonds. A cycloheteroalkyl group can have 3 to 24 ring atoms, for example, 3 to 20 ring atoms (e.g., 3-14 membered cycloheteroalkyl group). One or more N, P, S, or Se atoms (e.g., N or S) in a cycloheteroalkyl ring may be oxidized (e.g., morpholine N-oxide, thiomorpholine S-oxide, thiomorpholine S,S-dioxide). In some embodiments, nitrogen or phosphorus atoms of cycloheteroalkyl groups can bear a substituent, for example, a hydrogen atom, an alkyl group, or other substituents as described herein. Cycloheteroalkyl groups can also contain one or more oxo groups, such as oxopiperidyl, oxooxazolidyl, dioxo-(1H,3H)-pyrimidyl, oxo-2(1H)-pyridyl, and the like. Examples of cycloheteroalkyl groups include, among others, morpholinyl, thiomorpholinyl, pyranyl, imidazolidinyl, imidazolinyl, oxazolidinyl, pyrazolidinyl, pyrazolinyl, pyrrolidinyl, pyrrolinyl, tetrahydrofuranyl, tetrahydrothiophenyl, piperidinyl, piperazinyl, and the like. In some embodiments, cycloheteroalkyl groups can be substituted as described herein.

As used herein, "aryl" refers to an aromatic monocyclic hydrocarbon ring system or a polycyclic ring system in which two or more aromatic hydrocarbon rings are fused (i.e., having a bond in common with) together or at least one aromatic monocyclic hydrocarbon ring is fused to one or more cycloalkyl and/or cycloheteroalkyl rings. An aryl group can have 6 to 24 carbon atoms in its ring system (e.g., C₆₋₂₀ aryl group), which can include multiple fused rings. In some embodiments, a polycyclic aryl group can have 8 to 24 carbon atoms. Any suitable ring position of the aryl group can be covalently linked to the defined chemical structure. Preferred aryl groups having only aromatic carbocyclic ring(s) include phenyl, 1-naphthyl (bicyclic), 2-naphthyl (bicyclic), anthracenyl (tricyclic), phenanthrenyl (tricyclic), pentacenyl (pentacyclic), and like groups. Examples of polycyclic ring systems in which at least one aromatic carbocyclic ring is fused to one or more cycloalkyl and/or cycloheteroalkyl rings include, among others, benzo derivatives of cyclopentane (i.e., an indanyl group, which is a 5,6-bicyclic cycloalkyl/aromatic ring system), cyclohexane (i.e., a tetrahydronaphthyl group, which is a 6,6-bicyclic cycloalkyl/aromatic ring system), imidazoline (i.e., a benzimidazolinyl group, which is a 5,6-bicyclic cycloheteroalkyl/aromatic ring system), and pyran (i.e., a chromenyl group, which is a 6,6-bicyclic cycloheteroalkyl/aromatic ring system). Other preferred aryl groups include benzodioxanyl, benzodioxolyl, chromanyl, indolinyl groups, and the like. In some embodiments, aryl groups can be substituted as described herein. In some embodiments, an aryl group can have one or more halogen substituents, and can be referred to as a "haloaryl" group. Perhaloaryl groups, i.e., aryl groups where all of the hydrogen atoms are replaced with halogen atoms (e.g., -C₆F₅), are included within the definition of "haloaryl." In certain embodiments, an aryl group is substituted with another aryl group and can be referred to as a biaryl group. Each of the aryl groups in the biaryl group can be substituted as disclosed herein.

As used herein, "arylalkyl" refers to an -alkyl-aryl group, where the arylalkyl group is covalently linked to the defined chemical structure via the alkyl group. An arylalkyl group is within the definition of a -Y-C₆₋₁₄ aryl group, where Y is as defined herein. An preferred arylalkyl group is a benzyl group (-CH₂-C₆H₅). An arylalkyl group can be optionally substituted, i.e., the aryl group and/or the alkyl group, can be substituted as disclosed herein.

As used herein, "heteroaryl" refers to an aromatic monocyclic ring system containing at least one ring heteroatom selected from oxygen (O), nitrogen (N), sulfur (S), silicon (Si), and selenium (Se) or a polycyclic ring system where at least one of the rings present in the ring system is aromatic and contains at least one ring heteroatom. Polycyclic heteroaryl groups include those having two or more heteroaryl rings fused together, as well as those having at least one monocyclic heteroaryl ring fused to one or more aromatic carbocyclic rings, non-aromatic carbocyclic rings, and/or non-aromatic cycloheteroalkyl rings. A heteroaryl group, as a whole, can have, for example, 5 to 24 ring atoms and contain 1-5 ring heteroatoms (i.e., 5-20 membered heteroaryl group). The heteroaryl group can be attached to the defined chemical structure at any heteroatom or carbon atom that results in a stable structure. Generally, heteroaryl rings do not contain O-O, S-S, or S-O bonds. However, one or more N or S atoms in a heteroaryl group can be oxidized (e.g., pyridine N-oxide, thiophene S-oxide, thiophene S,S-dioxide). Preferred heteroaryl groups include, for example, the 5- or 6-membered monocyclic and 5-6 bicyclic ring systems shown below: 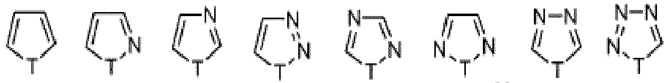 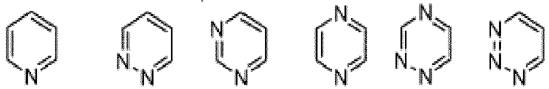 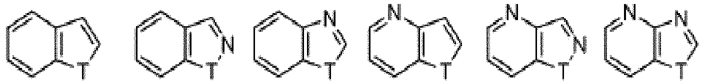 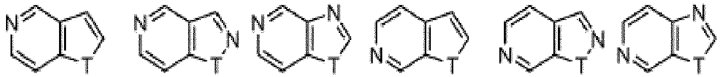 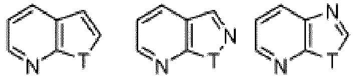 where T is O, S, NH, N-alkyl, N-aryl, N-(arylalkyl) (e.g., N-benzyl), SiH2, SiH(alkyl), Si(alkyl)₂, SiH(arylalkyl), Si(arylalkyl)₂, or Si(alkyl)(arylalkyl). More preferred heteroaryl rings include pyrrolyl, furyl, thienyl, pyridyl, pyrimidyl, pyridazinyl, pyrazinyl, triazolyl, tetrazolyl, pyrazolyl, imidazolyl, isothiazolyl, thiazolyl, thiadiazolyl, isoxazolyl, oxazolyl, oxadiazolyl, indolyl, isoindolyl, benzo furyl, benzothienyl, quinolyl, 2-methylquinolyl, isoquinolyl, quinoxalyl, quinazolyl, benzotriazolyl, benzimidazolyl, benzothiazolyl, benzisothiazolyl, benzisoxazolyl, benzoxadiazolyl, benzoxazolyl, cinnolinyl, 1H-indazolyl, 2H-indazolyl, indolizinyl, isobenzofuyl, naphthyridinyl, phthalazinyl, pteridinyl, purinyl, oxazolopyridinyl, thiazolopyridinyl, imidazopyridinyl, furopyridinyl, thienopyridinyl, pyridopyrimidinyl, pyridopyrazinyl, pyridopyridazinyl, thienothiazolyl, thienoxazolyl, thienoimidazolyl groups, and the like. Further more preferred heteroaryl groups include 4,5,6,7- tetrahydroindolyl, tetrahydroquinolinyl, benzothienopyridinyl, benzofuropyridinyl groups, and the like. In some embodiments, heteroaryl groups can be substituted as described herein.

In contrast to mono-valent groups compounds of the present teachings can include a "divalent group" defined herein as a linking group capable of forming a covalent bond with two other moieties. For example, compounds of the present teachings can include a divalent C₁₋₂₀ alkyl group (e.g., a methylene group), a divalent C₂₋₂₀ alkenyl group (e.g., a vinylyl group), a divalent C₂₋₂₀ alkynyl group (e.g., an ethynylyl group). a divalent C₆₋₁₄ aryl group (e.g., a phenylyl group); a divalent 3-14 membered cycloheteroalkyl group (e.g., a pyrrolidylyl), and/or a divalent 5-14 membered heteroaryl group (e.g., a thienylyl group). Generally, a chemical group (e.g., -Ar-) is understood to be divalent by the inclusion of the two bonds before and after the group.

The electron-donating or electron-withdrawing properties of several hundred of the most common substituents, reflecting all common classes of substituents have been determined, quantified, and published. The most common quantification of electron-donating and electron-withdrawing properties is in terms of Hammett σ values. Hydrogen has a Hammett σ value of zero, while other substituents have Hammett σ values that increase positively or negatively in direct relation to their electron-withdrawing or electron-donating characteristics. Substituents with negative Hammett σ values are considered electron donating, while those with positive Hammett σ values are considered electron-withdrawing. See Lange's Handbook of Chemistry, 12th ed., McGraw Hill, 1979, Table 3-12, pp. 3-134 to 3-138, which lists Hammett σ values for a large number of commonly encountered substituents and is incorporated by reference herein.

It should be understood that the term "electron-accepting group" can be used synonymously herein with "electron acceptor" and "electron-withdrawing group". In particular, an "electron-withdrawing group" ("EWG") or an "electron-accepting group" or an "electron-acceptor" refers to a functional group that draws electrons to itself more than a hydrogen atom would if it occupied the same position in a molecule. Preferred electron withdrawing groups include, but are not limited to, halogen or halo (e.g., F, Cl, Br, I), -NO₂, -CN, -NC, -S(R⁰)₂⁺, -N(R⁰)₃⁺, -SO₃H, -SO₂R⁰, -SO₃R⁰, -SO₂NHR⁰, -SO₂N(R⁰)₂, -COOH, -COR⁰, -COOR⁰, -CONHR⁰, -CON(R⁰)₂, C₁₋₄₀ haloalkyl groups, C₆₋₁₄ aryl groups, and 5-14 membered electron-poor heteroaryl groups; where R⁰ is a C₁₋₂₀ alkyl group, a C₂₋₂₀ alkenyl group, a C₂₋₂₀ alkynyl group, a C₁₋₂₀ haloalkyl group, a C₁₋₂₀ alkoxy group, a C₆₋₁₄ aryl group, a C₃₋₁₄ cycloalkyl group, a 3-14 membered cycloheteroalkyl group, and a 5-14 membered heteroaryl group, each of which can be optionally substituted as described herein. For example, each of the C₁₋₂₀ alkyl group, the C₂₋₂₀ alkenyl group, the C₂₋₂₀ alkynyl group, the C₁₋₂₀ haloalkyl group, the C₁₋₂₀ alkoxy group, the C₆₋₁₄ aryl group, the C₃₋₁₄ cycloalkyl group, the 3-14 membered cycloheteroalkyl group, and the 5-14 membered heteroaryl group can be optionally substituted with 1-5 small electron-withdrawing groups such as F, Cl, Br, -NO₂, -CN, -NC,-S(R⁰)₂⁺,-N(R⁰)₃⁺, - SO₃H, -SO₂R⁰, -SO₃R⁰, -SO₂NHR⁰, -SO₂N(R⁰)₂, -COOH, -COR⁰, -COOR⁰,-CONHR⁰, and - CON(R⁰)₂.

It should be understood that the term "electron-donating group" can be used synonymously herein with "electron donor". In particular, an "electron-donating group" or an "electron-donor" refers to a functional group that donates electrons to a neighboring atom more than a hydrogen atom would if it occupied the same position in a molecule. Preferred electron-donating groups include -OH, -OR⁰, - NH₂, -NHR⁰, -N(R⁰)₂, and 5-14 membered electron-rich heteroaryl groups, where R⁰ is a C₁₋₂₀ alkyl group, a C₂₋₂₀ alkenyl group, a C₂₋₂₀ alkynyl group, a C₆₋₁₄ aryl group, or a C₃₋₁₄ cycloalkyl group.

Various unsubstituted heteroaryl groups can be described as electron-rich (or π-excessive) or electron-poor (or π-deficient). Such classification is based on the average electron density on each ring atom as compared to that of a carbon atom in benzene. Preferred electron-rich systems include 5-membered heteroaryl groups having one heteroatom such as furan, pyrrole, and thiophene; and their benzofused counterparts such as benzofuran, benzopyrrole, and benzothiophene. Preferred electron-poor systems include 6-membered heteroaryl groups having one or more heteroatoms such as pyridine, pyrazine, pyridazine, and pyrimidine; as well as their benzofused counterparts such as quinoline, isoquinoline, quinoxaline, cinnoline, phthalazine, naphthyridine, quinazoline, phenanthridine, acridine, and purine. Mixed heteroaromatic rings can belong to either class depending on the type, number, and position of the one or more heteroatom(s) in the ring. *See* Katritzky, A.R and Lagowski, J.M., Heterocyclic Chemistry (John Wiley & Sons, New York, 1960).

At various places in the present specification, substituents are disclosed in groups or in ranges. It is specifically intended that the description include each and every individual subcombination of the members of such groups and ranges. For example, the term "C₁₋₆ alkyl" is specifically intended to individually disclose C₁, C₂, C₃, C₄, C₅, C₆, C₁-C₆, C₁-C₅, C₁-C₄, C₁-C₃, C₁-C₂, C₂-C₆, C₂-C₅, C₂-C₄, C₂-C₃, C₃-C₆, C₃-C₅, C₃-C₄, C₄-C₆, C₄-C₅, and C₅-C₆ alkyl. By way of other examples, an integer in the range of 0 to 40 is specifically intended to individually disclose 0, 1,2, 3,4, 5, 6, 7, 8, 9, 10, 11, 12, 13, 14, 15, 16, 17, 18, 19, 20, 21, 22, 23, 24, 25, 26, 27, 28, 29, 30, 31, 32, 33, 34, 35, 36, 37, 38, 39, and 40, and an integer in the range of 1 to 20 is specifically intended to individually disclose 1, 2, 3,4, 5, 6,7, 8, 9, 10, 11, 12, 13, 14, 15, 16, 17, 18, 19, and 20. Additional examples include that the phrase "optionally substituted with 1-5 substituents" is specifically intended to individually disclose a chemical group that can include 0, 1, 2, 3,4, 5, 0-5, 0-4, 0-3, 0-2, 0-1, 1-5, 1-4, 1-3, 1-2, 2-5, 2-4 ,2-3, 3-5, 3-4, and 4-5 substituents.

Compounds described herein can contain an asymmetric atom (also referred as a chiral center) and some of the compounds can contain two or more asymmetric atoms or centers, which can thus give rise to optical isomers (enantiomers) and geometric isomers (diastereomers). The present teachings include such optical and geometric isomers, including their respective resolved enantiomerically or diastereomerically pure isomers (e.g., (+) or (-) stereoisomer) and their racemic mixtures, as well as other mixtures of the enantiomers and diastereomers. In some embodiments, optical isomers can be obtained in enantiomerically enriched or pure form by standard procedures known to those skilled in the art, which include, for example, chiral separation, diastereomeric salt formation, kinetic resolution, and asymmetric synthesis. The present teachings also encompass cis- and trans-isomers of compounds containing alkenyl moieties *(e.g.,* alkenes, azo, and imines). It also should be understood that the compounds of the present teachings encompass all possible regioisomers in pure form and mixtures thereof. In some embodiments, the preparation of the present compounds can include separating such isomers using standard separation procedures known to those skilled in the art, for example, by using one or more of column chromatography, thin-layer chromatography, simulated moving-bed chromatography, and high-performance liquid chromatography. However, mixtures of regioisomers can be used similarly to the uses of each individual regioisomer of the present teachings as described herein and/or known by a skilled artisan.

It is specifically contemplated that the depiction of one regioisomer includes any other regioisomers and any regioisomeric mixtures unless specifically stated otherwise.

Throughout the specification, structures may or may not be presented with chemical names. Where any question arises as to nomenclature, the structure prevails.

The present teachings relate to polymeric compounds that can be used as organic semiconductor materials. The present compounds can have good solubility in various common solvents and good stability in air. When incorporated into optical or optoelectronic devices including, but not limited to, photovoltaic or solar cells, light emitting diodes, and light emitting transistors, the present compounds can confer various desirable performance properties. For example, when the present compounds are used in a photoactive layer of a solar cell (e.g., bulk heterojunction devices), the solar cell can exhibit very high power conversion efficiency (e.g., about 3.0% or greater).

The present teachings provide polymeric compounds based upon at least one repeating unit that includes an electron-poor polycyclic heteroaryl group that is substituted with one or more electron-withdrawing groups, thereby providing a strong acceptor moiety. For example, the electron-poor polycyclic heteroaryl group can be a bicyclic heteroaryl group that includes one or more nitrogen atoms. In some embodiments, the electron-poor polycyclic heteroaryl group can be a benzo-fused bicyclic heteroaryl group that includes one or more nitrogen atoms. In other embodiments, the electron-poor polycyclic heteroaryl group can be a pyrido-fused bicyclic heteroaryl group that includes two or more nitrogen atoms. Preferred electron-withdrawing groups include F, Cl, CN, an acyl group, and a haloalkyl group. To illustrate, various embodiments of the present polymers can be based upon at least one repeating unit that includes a benzo[c][1,2,5]thiadiazole (2,1,3-benzothiadiazole) i.e., which can be mono- or bis-substituted with electron-withdrawing groups R₁, R₂, R₃ or R₄.

The polymer compound of the present invention comprises at least one repeating unit represented by the formula (I), wherein R,¹, R², R³, R⁴, R⁵ and R⁶ are the same or mutually different and represent a hydrogen atom, a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a mono-valent heterocyclic group, a heterocyclic thio group, an amino group, a substituted amino group, a silyl group, a substituted silyl group, an acyl group, an acyloxy group, an imine residue, an amide group, an acid imide group, a carboxyl group, a substituted carboxyl group, a cyano group or a nitro group, and
X represents 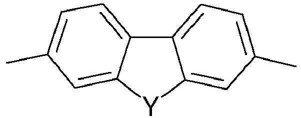 wherein Y = NR⁷ or CR⁸R⁹
k is a number of linearly linked thiophene units integrated in the repeating unit, preferably an integer from 1 to 3 and R⁷, R⁸, R⁹ have the same meanings as R¹, R², R³, R⁴, R⁵ or R⁶.

The present invention is preferably directed to a polymer compound with repeating units of formula (I) wherein R¹ represents preferably a hydrogen atom, a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group or a mono-valent heterocyclic group.

More preferred the present invention is directed to a polymer compound with repeating units of formula (I) wherein R¹ represents a hydrogen atom, a fluorine atom, an alkyl group or an aryl group.

Most preferred the present invention is directed to a polymer compound with repeating units of formula (I) wherein R¹ represents a hydrogen atom.

The alkyl group may be linear or branched, and may also be a cycloalkyl group. Preferably the alkyl group has a carbon atom number of usually 1 to 20. More preferred the alkyl group is selected from the group of a methyl group, an ethyl group, a n-propyl group, an i-propyl group, a n-butyl group, an i-butyl group, a t-butyl group, a s-butyl group, a 3-methylbutyl group, a n-pentyl group, a n-hexyl group, a 2-ethylhexyl group, a n-heptyl group, a n-octyl group, a n-nonyl group, a n-decyl group, a 3,7-dimethyloctyl group and a n-lauryl group. A hydrogen atom in the above-described alkyl group is optionally substituted by a fluorine atom. The alkyl group substituted by a fluorine atom is preferably a trifluoromethyl group, a pentafluoroethyl group, a perfluorobutyl group, a perfluorohexyl group, a perfluorooctyl group and the like.

The alkoxy group may be linear or branched, and may also be a cycloalkyloxy group. Preferably the alkoxy group has a carbon atom number of usually 1 to 20. More preferred the alkoxy group is selected from the group of a methoxy group, an ethoxy group, a propyloxy group, an i-propyloxy group, a n-butoxy group, an i-butoxy group, a s-butoxy group, a t-butoxy group, a n-pentyloxy group, a n-hexyloxy group, a cyclohexyloxy group, a n-heptyloxy group, a n-octyloxy group, a 2-ethylhexyloxy group, a n-nonyloxy group, a n-decyloxy group, a 3,7-dimethyloctyloxy group or a n-lauryloxy group. A hydrogen atom in the above-described alkoxy group is optionally substituted by a fluorine atom. The alkoxy group substituted by a fluorine atom is preferably a trifluoromethoxy group, a pentafluoroethoxy group, a perfluorobutoxy group, a perfluorohexyloxy group, a perfluorooctyloxy group and the like.

The alkylthio group may be linear or branched, and may also be a cycloalkylthio group. Preferably the alkylthio group has a carbon atom number of usually 1 to 20. More preferred the alkylthio group is selected from the group of a methylthio group, an ethylthio group, a n-propylthio group, an isopropylthio group, a n-butylthio group, an isobutylthio group, a s-butylthio group, a t-butylthio group, a n-pentylthio group, a n-hexylthio group, a cyclohexylthio group, a n-heptylthio group, a n-octylthio group, a 2-ethylhexylthio group, a n-nonylthio group, a n-decylthio group, a 3,7-dimethyloctylthio group or a n-laurylthio group. A hydrogen atom in the above-described alkylthio group is optionally substituted by a fluorine atom. The alkylthio group substituted by a fluorine atom is preferably a trifluoromethylthio group and the like.

The aryl group means an atomic group obtained by removing one hydrogen atom from an aromatic hydrocarbon, and includes also those having a condensed ring, and those having two or more independent benzene rings or condensed rings or two or more of both the rings, bonded directly or via a vinylene group or the like. The aryl group preferably has a carbon atom number of usually 6 to 60, more preferably 6 to 48. The above-described aryl group optionally has a substituent. This substituent includes linear or branched alkyl groups having a carbon atom number of 1 to 20, cycloalkyl groups having a carbon atom number of 3 to 20, alkoxy groups containing the alkyl group or the cycloalkyl group in its structure, groups represented by the formula (IV), and the like.

-O-(CH₂)_{gl}-O(CH₂)ₕₗ-CH₃ (IV)

wherein gl represents an integer of 1 to 6, and hl represents an integer of 0 to 5.

Preferred aryl groups are selected from the group of a phenyl group, C₁ to C₁₂ alkoxyphenyl groups (C₁ to C₁₂ means that the carbon atom number thereof is 1 to 12; the same shall apply hereinafter), C₁ to C₁₂ alkylphenyl groups, a 1-naphthyl group, a 2-naphthyl group, a 1-anthracenyl group, a 2-anthracenyl group, a 9-anthracenyl group, a pentafluorophenyl group and the like. More preferred are C₁ to C₁₂ alkoxyphenyl groups and C₁ to C₁₂ alkylphenyl groups. The C₁ to C₁₂ alkoxyphenyl group preferably includes a methoxyphenyl group, an ethoxyphenyl group, a n-propyloxyphenyl group, an isopropyloxyphenyl group, a n-butoxyphenyl group, an isobutoxyphenyl group, a s-butoxyphenyl group, a t-butoxyphenyl group, a n-pentyloxyphenyl group, a n-hexyloxyphenyl group, a cyclohexyloxyphenyl group, a n-heptyloxyphenyl group, a n-octyloxyphenyl group, a 2-ethylhexyloxyphenyl group, a n-nonyloxyphenyl groups, a n-decyloxyphenyl group, a 3,7-dimethyloctyloxyphenyl group and a n-lauryloxyphenyl group. The C₁ to C₁₂ alkylphenyl group preferably includes a methylphenyl group, an ethylphenyl group, a dimethylphenyl group, a n-propylphenyl group, a mesityl group, a methylethylphenyl group, an isopropylphenyl group, a n-butylphenyl group, an isobutylphenyl group, a s-butylphenyl group, a t-butylphenyl group, a n-pentylphenyl group, an isoamylphenyl group, a n-hexylphenyl group, a n-heptylphenyl group, a n-octylphenyl group, a n-nonylphenyl group, a n-decylphenyl group, a n-dodecylphenyl group, and the like. A hydrogen atom in the above-described aryl group is optionally substituted by a fluorine atom.

The aryloxy group has preferably a carbon atom number of 6 to 60, more preferably of 6 to 48. Preferred aryloxy groups are those selected from the group of a phenoxy group, C₁ to C₁₂ alkoxyphenoxy groups, C₁ to C₁₂ alkylphenoxy groups, a 1-naphthyloxy group, a 2-naphthyloxy group, a pentafluorophenyloxy group and the like. More preferred are C₁ to C₁₂ alkoxyphenoxy groups and C₁ to C₁₂ alkylphenoxy groups. The C₁ to C₁₂ alkoxy is preferably selected from the group of methoxy, ethoxy, n-propyloxy, isopropyloxy, n-butoxy, isobutoxy, s-butoxy, t-butoxy, n-pentyloxy, n-hexyloxy, cyclohexyloxy, n-heptyloxy, n-octyloxy, 2-ethylhexyloxy, n-nonyloxy, n-decyloxy, 3,7-dimethyloctyloxy and n-lauryloxy. The C₁ to C₁₂ alkylphenoxy group is preferably selected from the group of a methylphenoxy group, an ethylphenoxy group, a dimethylphenoxy group, a n-propylphenoxy group, a 1,3,5-trimethylphenoxy group, a methylethylphenoxy group, an isopropylphenoxy group, a n-butylphenoxy group, an isobutylphenoxy group, a s-butylphenoxy group, a t-butylphenoxy group, a n-pentylphenoxy group, an isoamylphenoxy group, a n-hexylphenoxy group, a n-heptylphenoxy group, a n-octylphenoxy group, a n-nonylphenoxy group, a n-decylphenoxy group, a n-dodecylphenoxy group and the like.

The arylthio group or the heterocycle with at least one sulphur atom optionally has a substituent on an aromatic ring, and preferably has a carbon atom number of 6 to 60. The arylthio group is preferably selected from the group of a phenylthio group, C₁ to C₁₂ alkoxyphenylthio group, C₁ to C₁₂ alkylphenylthio group, a 1-naphthylthio group, a 2-naphthylthio group, a pentafluorophenylthio group, a pyridylthio group, a pyridazinylthio group, a pyrimidylthio group, a pyrazylthio group and a triazylthio group.

The arylalkyl group optionally has a substituent, and preferably has a carbon atom number of 7 to 60. The arylalkyl group is preferably selected from the group of phenyl-C₁ to C₁₂-alkyl groups, C₁ to C₁₂-alkoxyphenyl-C₁ to C₁₂ -alkyl groups, C₁ to C₁₂-alkylphenyl-C₁ to C₁₂-alkyl groups, 1-naphthyl-C₁ to C₁₂-alkyl groups and 2-naphthyl-C₁ to C₁₂-alkyl groups.

The arylalkoxy group optionally has a substituent, and preferably has a carbon atom number of 7 to 60. The aylalkoxy group is preferably selected from the group of phenyl-C₁ to C₁₂-alkoxy groups, C₁ to C₁₂-alkoxyphenyl-C₁ to C₁₂-alkoxy groups, C₁ to C₁₂-alkylphenyl-C₁ to C₁₂-alkoxy groups, 1-naphthyl-C₁ to C₁₂-alkoxy groups and 2-naphthyl-C₁ to C₁₂-alkoxy groups.

The arylalkylthio group optionally has a substituent, and preferably has a carbon atom number of 7 to 60. The arylalkylthio group is selected from the group of phenyl-C₁ to C₁₂-alkylthio groups, C₁ to C₁₂-alkoxyphenyl-C₁ to C₁₂-alkylthio groups, C₁ to C₁₂-alkylphenyl-C₁ to C₁₂-alkylthio groups, 1-naphthyl-C₁ to C₁₂₋alkylthio groups and 2-naphthyl-C₁ to C₁₂-alkylthio groups.

The arylalkenyl group has preferably a carbon atom number of 8 to 60. The arylalkenyl group is preferably selected from the group of phenyl-C₂ to C₁₂-alkenyl groups, C₁ to C₁₂-alkoxyphenyl-C₂ to C₁₂-alkenyl groups, C₁ to C₁₂-alkylphenyl-C₂ to C₁₂-alkenyl groups, 1-naphthyl-C₂ to C₁₂-alkenyl groups and 2-naphthyl-C₂ to C₁₂-alkenyl groups, and more preferred are C₁ to C₁₂-alkoxyphenyl-C₂ to C₁₂-alkenyl groups and C₁ to C₁₂-alkylphenyl-C₂ to C₁₂-alkenyl groups, 1-naphtyl-C₂ to C₁₂-alkenyl groups and 2-naphtyl-C₂ to C₁₂-alkenyl groups, and most preferred are C₁ to C₁₂-alkoxyphenyl-C₂ to C₁₂-alkenyl groups and C₁ to C₁₂-alkylphenyl-C₂ to C₁₂-alkenyl groups.

The arylalkynyl group has preferably a carbon atom number of 8 to 60. The arylalkynyl group is preferably selected from the group of phenyl-C₂ to C₁₂-alkynyl groups, C₁ to C₁₂-alkoxyphenyl-C₂ to C₁₂-alkynyl groups, C₁ to C₁₂-alkylphenyl-C₂ to C₁₂-alkynyl groups, 1-naphthyl-C₂ to C₁₂-alkynyl groups and 2-naphthyl-C₂ to C₁₂-alkynyl groups, and more preferred are C₁₂ to C₁₂-alkoxyphenyl-C₂ to C₁₂-alkynyl groups and C₁ to C₁₂-alkylphenyl-C₂ to C₁₂-alkynyl groups.

The mono-valent heterocyclic group means an atomic group remaining after removing one hydrogen atom from a heterocyclic compound. The mono-valent heterocyclic group has preferably a carbon atom number of 4 to 60, more preferred of 4 to 20. The carbon atom number of the mono-valent heterocyclic group does not include the carbon atom number of the substituent. The above-described heterocyclic compound means an organic compound having a cyclic structure in which elements constituting the ring include not only a carbon atom, but also a hetero atom selected from the group of oxygen, sulfur, nitrogen, phosphorus, boron, silicon and the like contained in the ring. Preferred mono-valent heterocyclic groups are selected from the group of a thienyl group, C₁ to C₁₂-alkylthienyl groups, a pyrrolyl group, a furyl group, a pyridyl group, C₁ to C₁₂-alkylpyridyl groups, a piperidyl group, a quinolyl group and an isoquinolyl group. More preferred are a thienyl group, a C₁ to C₁₂-alkylthienyl group, a pyridyl group and a C₁ to C₁₂-alkylpyridyl group. Of the mono-valent heterocyclic groups, mono-valent aromatic heterocyclic groups are preferable.

The heterocyclic thio group means a group obtained by substituting a hydrogen atom of a mercapto group by a mono-valent heterocyclic group. The heterocyclic thio group includes hetero arylthio groups, preferably a pyridylthio group, a pyridazinylthio group, a pyrimidylthio group, a pyrazinylthio group, a triazinylthio group and the like.

The substituted amino group includes amino groups substituted by one or two groups selected from the group consisting of an alkyl group, an aryl group, an arylalkyl group and a mono-valent heterocyclic group, and the alkyl group, aryl group, arylalkyl group and mono-valent heterocyclic group optionally have a substituent. The carbon atom number of the substituted amino group is preferably 1 to 60, more preferred 2 to 48, not including the carbon atom number of the substituent. Preferred substituted amino groups are selected from the group of a methylamino group, a dimethylamino group, an ethylamino group, a diethylamino group, a n-propylamino group, a di-n-propylamino group, an isopropylamino group, a diisopropylamino group, a n-butylamino group, a s-butylamino group, an isobutylamino group, a t-butylamino group, a n-pentylamino group, a n-hexylamino group, a cyclohexylamino group, a n-heptylamino group, a n-octylamino group, a 2-ethylhexylamino group, a n-nonylamino group, a n-decylamino group, a 3,7-dimethyloctylamino group, a n-laurylamino group, a cyclopentylamino group, a dicyclopentylamino group, a cyclohexylamino group, a dicyclohexylamino group, a pyrrolidyl group, a piperidyl group, a ditrifluoromethylamino group, a phenylamino group, a diphenylamino group, a C₁ to C₁₂-alkoxyphenylamino group, a di(C₁ to C₁₂-alkoxyphenyl)-amino group, a di(C₁ to C₁₂ alkylphenyl)-amino group, a 1 -naphthylamino group, a 2-naphthylamino group, a pentafluorophenylamino group, a pyridylamino group, a pyridazinylamino group, a pyrimidylamino group, a pyrazylamino group, a triazylamino group, phenyl-C₁ to C₁₂-alkylamino groups, a C₁ to C₁₂-alkoxyphenyl-C₁ to C₁₂-alkylamino group, a C₁ to C₁₂-alkylphenyl-C₁ to C₁₂-alkylamino group, a di(C₁ to C₁₂-alkoxyphenyl-C₁ to C₁₂-alkyl) amino group, a di(C₁ to C₁₂-alkylphenyl-C₁ to C₁₂-alkyl) amino group, a 1-naphthyl-C₁ to C₁₂-alkylamino group and a 2-naphthyl-C₁ to C₁₂-alkylamino group.

The substituted silyl group includes silyl groups substituted by one, two or three groups selected from the group consisting of an alkyl group, an aryl group, an arylalkyl group and a mono-valent heterocyclic group. The substituted silyl group has preferably a carbon atom number of 1 to 60, more preferred of 3 to 48. The alkyl group, aryl group, aylalkyl group and mono-valent heterocyclic group optionally have a substituent.

Preferred silyl groups are selected from the group of a trimethylsilyl group, a triethylsilyl group, a tri-n-propylsilyl group, a tri-isopropylsilyl group, a dimethyl-isopropylsilyl group, a diethyl-isopropylsilyl group, a t-butyldimethylsilyl group, a n-pentyldimethylsilyl group, a n-hexyldimethylsilyl group, a n-heptyldimethylsilyl group, a n-octyldimethylsilyl group, a 2-ethylhexyl-dimethylsilyl group, a n-nonyldimethylsilyl group, a n-decyldimethylsilyl group, a 3,7-dimethyloctyl-dimethylsilyl group, a n-lauryldimethylsilyl group, a phenyl-C₁ to C₁₂-alkylsilyl group, a C₁ to C₁₂-alkoxyphenyl-C₁ to C₁₂-alkylsilyl group, a C₁ to C₁₂-alkylphenyl-C₁ to C₁₂-alkylsilyl group, a 1-naphthyl-C₁ to C₁₂-alkylsilyl group, a 2-naphthyl-C₁ to C₁₂-alkylsilyl group, a phenyl-C₁ to C₁₂-alkyldimethylsilyl group, a triphenylsilyl group, a tri-p-xylylsilyl group, a tribenzylsilyl group, a diphenylmethylsilyl group, a t-butyldiphenylsilyl group and a dimethylphenylsilyl group.

The acyl group has preferably a carbon atom number of 2 to 20, more preferred of 2 to 18. Preferred acyl groups are selected from the group of a propionyl group, a butyryl group, an isobutyryl group, a pivaloyl group, a benzoyl group, a trifluoroacetyl group and a pentafluorobenzoyl group.

The acyloxy group has preferably a carbon atom number of 2 to 20, more preferred of 2 to 18. Preferred acyloxy groups are selected from the group of an acetoxy group, a propionyloxy group, a butyryloxy group, an isobutyryloxy group, a pivaloyloxy group, a benzoyloxy group, a trifluoroacetyloxy group and a pentafluorobenzoyloxy group.

The imine residue includes residues obtained by removing one hydrogen atom from imine compounds - namely, meaning organic compounds having -N=C- in the molecule. Preferred imine residues are selected from the group of aldimines, ketimines, and compounds obtained by substituting a hydrogen atom on N in these compounds by an alkyl group or the like. The imine residue has preferably a carbon atom number of 2 to 20, more preferred of 2 to 18. Preferred imine residues are selected from the groups represented by the following structural formulae: 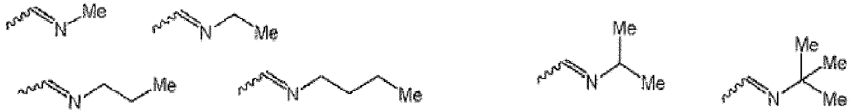 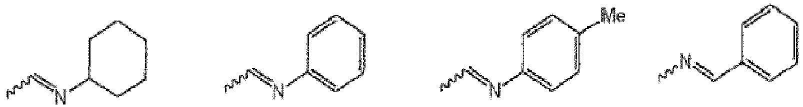 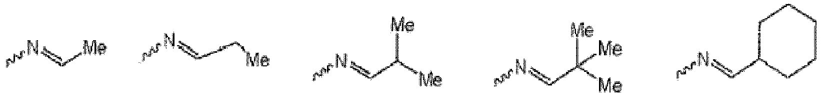 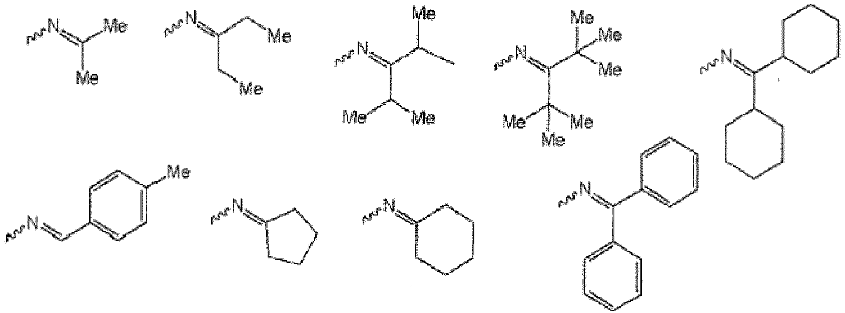 wherein in each case Me represents a methyl group, and the same shall apply hereinafter. The wavy line represents a connecting bond, and means a possibility of a geometric isomer such as a cis body, a trans body or the like depending on the kind of the imine residue.

The amide group has preferably a carbon atom number of 2 to 20, more preferred of 2 to 18. Preferred amide groups are selected from the group of a formamide group, an acetamide group, a propionamide group, a butyroamide group, a benzamide group, a trifluoroacetamide group, a pentafluorobenzamide group, a diformamide group, a diacetamide group, a dipropioamide group, a dibutyroamide group, a dibenzamide group, a ditrifluoroacetamide group and a dipentafluorobenzamide group.

The acid imide group includes residues obtained by removing from an acid imide one hydrogen atom connected to its nitrogen atom, and has a carbon atom number preferably of 4 to 20. Preferred acid imide groups are selected from the groups shown below:

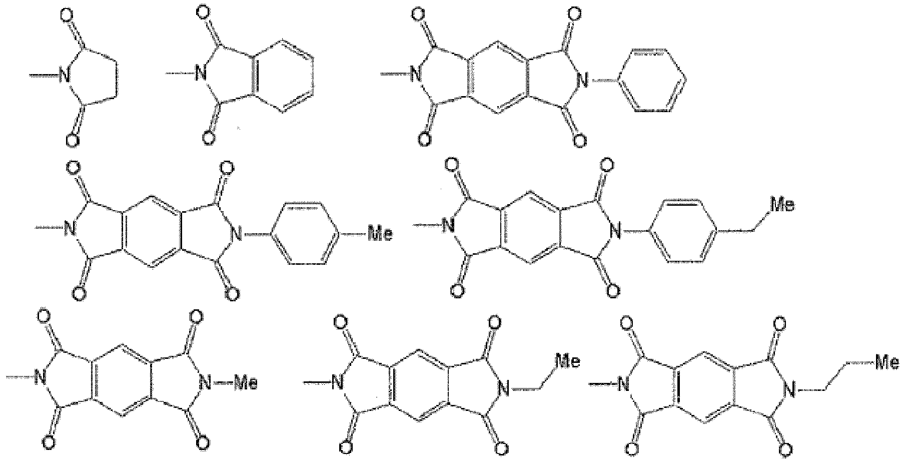

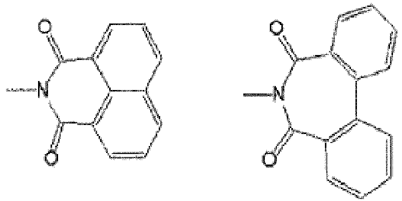

The substituted carboxyl group includes carboxyl groups substituted by an alkyl group, an aryl group, an arylalkyl group or a mono-valent heterocyclic group. The above-described alkyl group, aryl group, arylalkyl group and mono-valent heterocyclic group optionally have a substituent. The substituted carboxyl group has preferably a carbon atom number of 2 to 60, more preferred of 2 to 48. The carbon atom number of the substituted carboxyl group does not include the carbon atom number of the substituent. Preferred substituted carboxyl groups are selected from the group of a methoxycarbonyl group, an ethoxycarbonyl group, a n-propoxycarbonyl group, an isopropoxycarbonyl group, a n-butoxycarbonyl group, an isobutoxycarbonyl group, a t-butoxycarbonyl group, a n-pentyloxycarbonyl group, a n-hexyloxycarbonyl group, a cyclohexyloxycarbonyl group, a n-heptyloxycarbonyl group, a n-octyloxycarbonyl group, a 2-ethylhexyloxycarbonyl group, a n-nonyloxycarbonyl group, a n-decyloxycarbonyl group, a 3,7-dimethyloctyloxycarbonyl group, a n-dodecyloxycarbonyl group, a trifluoromethoxycarbonyl group, a pentafluoroethoxycarbonyl group, a perfluorobutoxycarbonyl group, a per-fluorohexyloxycarbonyl group, a perfluorooctyloxycarbonyl group, a phenoxycarbonyl group, a naphthoxycarbonyl group and a pyridyloxycarbonyl group.

In a most preferred embodiment the present invention is directed to a polymer compound comprising repeating units represented by formula (II) 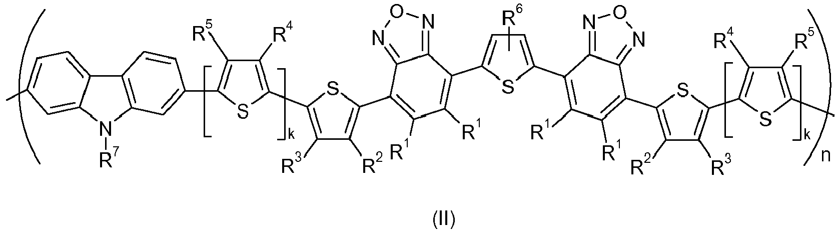 wherein k is a number of linearly linked thiophene units integrated in the repeating unit, preferably an integer from 1 to 3,
n is the number of repeating units, preferably from 2 to 2000, and
R¹, R², R³, R⁴, R⁵, R⁶ and R⁷ are the same or mutually different and represent a hydrogen atom, a halogen atom, an alkyl group, an alkoxy group, an alkylthio group, an aryl group, an aryloxy group, an arytlthio group, a heterocyclic group, preferably a mono-valent-heterocyclic group, a heterocyclic group with at least one sulphur atom, an amino group, a substituted amino group, a silyl group, a substituted silyl group, an acyl group, an acyloxy group, an imine group, an amide group, an acid imide group, a carboxyl group, a substituted carboxyl group, a cyano group or a nitro group.

On each of the end groups the polymer compound comprising repeating units of formula (II) preferably bears end groups EG1 and EG2 each independent from each other represents hydrogen, halogen, trialkylstannyl (-Sn(Alkyl)₃), boronic acid (-B(OH)₂), boronic ester (-B(OAlkyl)₂), aryl or a mono-valent heterocyclic group, preferably hydrogen, bromine or a phenyl group.

In such case the polymer compound comprising repeating units of formula (II) is represented by formula (II') 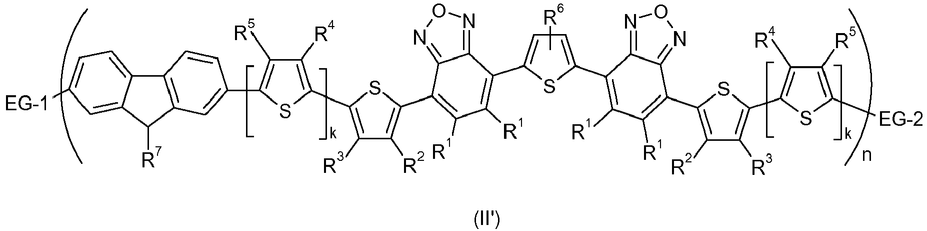 wherein integer k is a number of linearly linked thiophene units integrated in the repeating unit, preferably from 1 to 3, n is the number of repeating units, preferably from 2 to 2000, and
R¹, R², R³, R⁴, R⁵, R⁶ and R⁷ are the same or mutually different and represent a hydrogen atom, a halogen atom, an alkyl group, an alkoxy group, an alkylthio group, an aryl group, an aryloxy group, an arytlthio group, a heterocyclic group, preferably a mono-valent-heterocyclic group, a heterocyclic group with at least one sulphur atom, an amino group, a substituted amino group, a silyl group, a substituted silyl group, an acyl group, an acyloxy group, an imine group, an amide group, an acid imide group, a carboxyl group, a substituted carboxyl group, a cyano group or a nitro group,
EG-1 and EG-2 are the end groups of the polymer compound and independent from each other are represented by hydrogen, halogen, trialkylstannyl (-Sn(Alkyl)₃), boronic acid (-B(OH)₂), boronic ester (-B(OAlkyl)₂) or an aryl unit.

In the context of the present invention the prefix "poly" is understood to mean that more than one identical or different repeating units of the general formula (II) are present in the polymer compound of formula (II'). The polymer compounds of formula (II') according to the present invention contain a total of n repeating units of the general formula (II) where n preferably is an integer from 2 to 2000, more preferred from 2 to 200. The repeating units of the general formula (II) may each be the same or different within a polymer compound according to the present invention. Preference is given to a polymer compound containing identical repeating units of the general formula (II) in each case.

In a more preferred embodiment the present invention is directed to a polymer compound comprising repeating units of formula (II) wherein R¹ represents a hydrogen atom or a fluorine atom and R², R³, R⁴, R⁵, R⁶ and R⁷ are the same or different and each represents a hydrogen atom or a C₁-C₂₀ alkyl group while k is a number of linearly linked thiophene units integrated in the repeating unit, preferably an integer from 1 to 3, and n is the number of repeating units, preferably from 2 to 2000.

In a more preferred embodiment the present invention is directed to a polymer compound comprising repeating units of formula (II) wherein R¹ represents a hydrogen atom or a fluorine atom and R², R³, R⁴, R⁵ and R⁶ are the same or different and each represents a hydrogen atom or a C₁-C₁₀ alkyl group and R⁷ represents a C₁-C₂₀ alkyl group while k is a number of linearly linked thiophene units integrated in the repeating unit, preferably an integer from 1 to 3 and n is the number of repeating units, preferably from 2 to 2000.

In a very preferred embodiment the present invention is directed to a polymer compound comprising repeating units of formula (II) wherein R¹ represents a hydrogen atom or a fluorine atom, R², R³ and R⁴ are the same and each represents a hydrogen atom, R⁵ represents a C₁-C₁₀ alkyl group, R⁶ represents a hydrogen atom or a C₁-C₁₀ alkyl group, and R⁷ represents a C₁-C₂₀ alkyl group while k is a number of linearly linked thiophene units integrated in the repeating unit, preferably an integer from 1 to 3 and n is the number of repeating units, preferably from 2 to 2000.

In another very preferred embodiment the present invention is directed to a polymer compound comprising repeating units of formula (II) wherein R¹ represents a hydrogen atom or a fluorine atom, R², R³ and R⁵ are the same and each represents a hydrogen atom, R⁴ represents a C₁-C₁₀ alkyl group, R⁶ represents a hydrogen atom or a C₁-C₁₀ alkyl group, and R₇ represents a C₁-C₂₀ alkyl group while k is a number of linearly linked thiophene units integrated in the repeating unit, preferably an integer from 1 to 3 and n is the number of repeating units, preferably from 2 to 2000.

In a most preferred embodiment the present invention is directed to a polymer compound comprising repeating units of formula (II) wherein R¹ represents a hydrogen atom or a fluorine atom, R² and R⁴ are the same and each represents a C₁-C₁₀ alkyl group, R³ and R⁵ are the same and each represents a hydrogen atom, R⁶ represents a hydrogen atom or a C₁-C₁₀ alkyl group, and R⁷ represents a C₁-C₂₀ alkyl group while k is a number of linearly linked thiophene units integrated in the repeating unit, preferably an integer from 1 to 3 and n is the number of repeating units, preferably from 2 to 2000.

In a most preferred embodiment the present invention is directed to a polymer compound comprising repeating units of formula (II) wherein R¹ represents a hydrogen atom or a fluorine atom, R² and R⁴ are the same and each represents a hydrogen atom, R³ and R⁵ are the same and each represents a C₁-C₁₀ alkyl group, R⁶ represents a hydrogen atom or a C₁-C₁₀ alkyl group, and R₇ represents a C₁-C₂₀ alkyl group while k is a number of linearly linked thiophene units integrated in the repeating unit, preferably an integer from 1 to 3 and n is the number of repeating units, preferably from 2 to 2000.

In an especial preferred embodiment the present invention is directed to a polymer compound comprising repeating units of formula (II) wherein R¹ represents a hydrogen atom, R² and R⁴ are the same and each represents a hydrogen atom, R³ and R⁵ are the same and each represents a C₈ alkyl group, R⁶ represents a hydrogen atom, and R⁷ represents a C₁₇ alkyl group and to a polymer compound comprising repeating units of formula (II) wherein R¹ represents a hydrogen atom, R² and R⁴ are the same and each represents a C₈ alkyl group, R³ and R⁵ are the same and each represents a hydrogen atom, R⁶ represents a hydrogen atom, and R⁷ represents a C₁₇ alkyl group while k is a number of linearly linked thiophene units integrated in the repeating unit, preferably an integer from 1 to 3 and n is the number of repeating units, preferably from 2 to 2000.

In another most preferred embodiment the present invention is directed to a polymer compound comprising repeating units represented by formula (III) 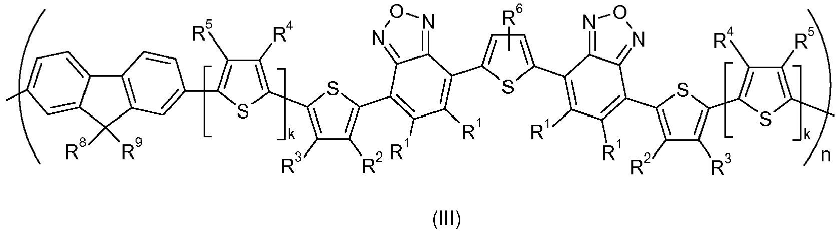 wherein
k is a number of linearly linked thiophene units integrated in the repeating unit, preferably an integer from 1 to 3, n is the number of repeating units, preferably from 2 to 2000, and
R¹, R², R³, R⁴, R⁵, R⁶, R⁸ and R⁹ are the same or mutually different and represent a hydrogen atom, a halogen atom, an alkyl group, an alkoxy group, an alkylthio group, an aryl group, an aryloxy group, an arylthio group, a heterocyclic group, preferably a mono-valent-heterocyclic group, a heterocyclic group wit at least one sulphur atom, an amino group, a substituted amino group, a silyl group, a substituted silyl group, an acyl group, an acyloxy group, an imine group, an amide group, an acid imide group, a carboxyl group, a substituted carboxyl group, a cyano group or a nitro group.

On each of the end groups the polymer compound comprising repeating units of formula (III) preferably bears end groups EG1 and EG2 each independent from each other represents hydrogen, halogen, trialkylstannyl (-Sn(Alkyl)₃), boronic acid (-B(OH)₂), boronic ester (-B(OAlkyl)₂), aryl or a mono-valent heterocyclic group, preferably hydrogen, bromine or a phenyl group.

A polymer compound comprising repeating units of formula (III) is characterized by formula (III') 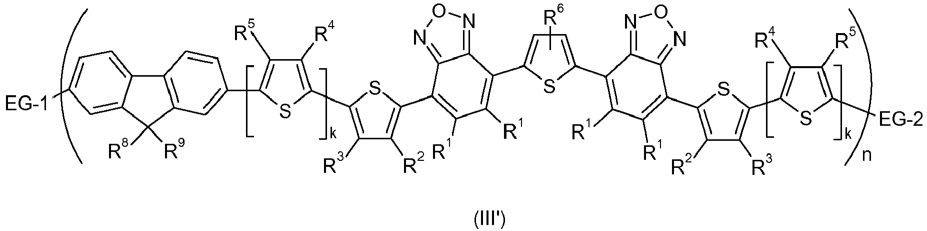 wherein n is the number of repeating units, preferably from 2 to 2000, k is a number of linearly linked thiophene units integrated in the repeating unit, preferably an integer from 1 to 3, and R¹, R², R³, R⁴, R⁵, R⁶, R⁸ and R⁹ are the same or mutually different and represent a hydrogen atom, a halogen atom, an alkyl group, an alkoxy group, an alkylthio group, an aryl group, an aryloxy group, an arylthio group, a heterocyclic group, preferably a mono-valent-heterocyclic group, a heterocyclic group with at least one sulphur atom, an amino group, a substituted amino group, a silyl group, a substituted silyl group, an acyl group, an acyloxy group, an imine group, an amide group, an acid imide group, a carboxyl group, a substituted carboxyl group, a cyano group or a nitro group, EG-1 and EG-2 are the end groups of the polymer compound and independent from each other are represented by hydrogen, halogen, trialkylstannyl (-Sn(Alkyl)₃), boronic acid (-B(OH)₂), boronic ester (-B(OAlkyl)₂) or an aryl unit, preferably hydrogen, bromine or a phenyl unit.

In the context of the present invention the prefix "poly" is understood to mean that more than one identical or different repeating units of the general formula (III) are present in the polymer compound of formula (III'). The polymer compounds of formula (III') according to the present invention contain a total of n repeating units of the general formula (III) where n preferably is an integer from 2 to 2000, more preferred from 2 to 200. The repeating units of the general formula (III) may each be the same or different within a polymer compound according to the present invention. Preference is given to a polymer compound containing identical repeating units of the general formula (III) in each case.

In a more preferred embodiment the present invention is directed to a polymer compound comprising repeating units of formula (III) wherein R¹ represents a hydrogen atom or a fluorine atom and R², R³, R⁴, R⁵, R⁶, R⁸ and R⁹ are the same or different and each represents a hydrogen atom or a C₁-C₂₀ alkyl group while k and n have the meanings described above.

In other more preferred embodiment the present invention is directed to a polymer compound comprising repeating units of formula (III) wherein R¹ represents a hydrogen atom or a fluorine atom and R², R³, R⁴, R⁵ and R⁶ are the same or different and each represents a hydrogen atom or a C₁-C₁₀ alkyl group, R⁸ and R⁹ are the same and each represents a C₁-C₂₀ alkyl group while k and n have the meanings described above.

In a very preferred embodiment the present invention is directed to a polymer compound comprising repeating units of formula (III) wherein R¹ represents a hydrogen atom or a fluorine atom, R², R³ and R⁴ are the same and each represents a hydrogen atom, R⁵ represents a C₁-C₁₀ alkyl group, R⁶ represents a hydrogen atom or a C₁-C₁₀ alkyl group, R⁸ and R⁹ are the same and each represents a C₁-C₂₀ alkyl group while k and n have the meanings described above.

In other very preferred embodiment the present invention is directed to a polymer compound comprising repeating units of formula (III) wherein R¹ represents a hydrogen atom or a fluorine atom, R², R³ and R⁵ are the same and each represents a hydrogen atom, R⁴ represents a C₁-C₁₀ alkyl group, R⁶ represents a hydrogen atom or a C₁-C₁₀ alkyl group, R⁸ and R⁹ are the same and each represents a C₁-C₂₀ alkyl group while k and n have the meanings described above.

In a most preferred embodiment the present invention is directed to a polymer compound comprising repeating units of formula (III) wherein R¹ represents a hydrogen atom or a fluorine atom, R² and R⁴ are the same and each represents a C₁-C₁₀ alkyl group, R³ and R⁵ are the same and each represents a hydrogen atom, R⁶ represents a hydrogen atom or a C₁-C₁₀ alkyl group, R⁸ and R⁹ are the same and each represents a C₁-C₂₀ alkyl group while k and n have the meanings described above.

In a most preferred embodiment the present invention is directed to a polymer compound comprising repeating units of formula (III) wherein R¹ represents a hydrogen atom or a fluorine atom, R² and R⁴ are the same and each represents a hydrogen atom, R³ and R⁵ are the same and each represents a C₁-C₁₀ alkyl group, R₆ represents a hydrogen atom or a C₁-C₁₀ alkyl group, R⁸ and R⁹ are the same and each represents a C₁-C₂₀ alkyl group while k and n have the meanings described above.

In an especial preferred embodiment the present invention is directed to a polymer compound comprising repeating units of formula (III) wherein R¹ represents a hydrogen atom, R² and R⁴ are the same and each represents a hydrogen atom, R³ and R⁵ are the same and each represents a C₈ alkyl group, R⁶ represents a hydrogen atom, and R⁸ and R⁹ are the same and each represents a C₈ alkyl group and to a polymer compound comprising repeating units of formula (III) wherein R¹ represents a hydrogen atom, R² and R⁴ are the same and each represents a C₈ alkyl group, R³ and R⁵ are the same and each represents a hydrogen atom, R₆ represents a hydrogen atom, R⁸ and R⁹ are the same and each represents a C₈ alkyl group while k and n have the meanings described above.

In a preferred embodiment the present invention is directed to a polymer compound according to formula (I') , (II') or (III') wherein k=1.

In another preferred embodiment the present invention is directed to a polymer compound according to formula (I') , (II') or (III') wherein k=2.

In another preferred embodiment the present invention is directed to a polymer compound according to formula (I') , (II') or (III') wherein k=3.

A composition of the present invention is a composition containing at least one polymer compound of the present invention, and includes a composition containing at least one material selected from the group consisting of a hole transporting material, an electron acceptor material, an electron transporting material and a light absorbing material, and containing at least one polymer compound of the present invention, a composition containing at least two polymer compounds of the present invention, and the like.

A composition of the present invention is preferably a liquid composition, and is useful for fabrication of light absorbing devices such as polymer light emitting devices, and organic transistors. The liquid composition contains at least one of the above-described polymer compounds and a solvent. In this specification, "liquid composition" means a composition which is liquid in device fabrication, and usually, is liquid at normal pressure at 1 atm (1 bar) and at 25°C. The liquid composition is, in general, referred to as ink, ink composition, solution or the like in some cases.

In a preferred embodiment the liquid composition contains an additive selected from the group of an additives with boiling temperature below 450 °C affecting the structure of the thin films obtained after drying the liquid composition, low molecular weight fluorescent material an electron acceptor material, a hole transporting material, an electron transporting material, a stabilizer, additives for adjusting viscosity and/or surface tension, an antioxidant and the like, in addition to the above-described polymer compound. These optional components may be used each singly or in combination of two or more.

Preferred low molecular weight additives with boiling temperature below 450 °C include C₈-C₂₂ aliphatic hydrocarbons (tetradecane, hexadecane and alike), halogenated alkanes (1,8-diiodooctane, perfluoro-1,8-diiodoctane, 1,8-dibromooctane, 1,6-dibromohexaneperfuorotetradecane and alike), aliphatic thiols (1,8-octanedithiol, 1,6-octanedithiol, 1-dodecylthiol and alike), acids and esters comprising thiol group (methyl 2-mercaptoacetate,n-butyl 2-mercaptoacetate, ethyl 3-mercaptopropionate, 3-mercaptopropionic acid, 11-mercaptoundecanoic acid and alike), aromatic ethers (diphenyl ether, methylphenyl ether and alike), ketones (acetophenone, valerophenone and alike), aldehydes (e.g. propional, perfuorooctanal and alike), aliphatic esters (butylacetate, methyl ester of perfluorohexanoic acidand alike), substituted aromatic hydrocarbons (2-chloronaphthalene, 1-bromonaphthalene, benzyl alcohol, pentafluorobenzyl alcohol, 1,4-dibromobenzene, thiophenol and alike).

Preferred electron acceptor materials include unmodified fullerenes, fullerene derivatives, n-type conjugated polymers, derivatives of naphthalene, perylene, nanocrystals of inorganic n-type semiconductors, and other types of organic compounds with LUMO energy (or inorganic compounds with their valence band) of -3.5 eV or lower (e.g. -3.6 eV, -3.8 eV and etc) as estimated *vs*. vacuum level.

Preferred low molecular weight fluorescent materials which may be contained in the liquid composition include low molecular weight fluorescent materials from the group of naphthalene derivatives, anthracene, anthracene derivatives, perylene, perylene derivatives, polymethine dyes, xanthene dyes, coumarine dyes, cyanine dyes; metal complexes having a metal complex of 8-hydroxyquinoline as a ligand; metal complexes having a 8-hydroxyquinoline derivative as a ligand; other fluorescent metal complexes, aromatic amines, tetraphenylcyclopentadiene, tetraphenylcyclopentadiene derivatives, tetraphenylcyclobutadiene, tetraphenylcyclobutadiene derivatives, stilbenes, silicon-containing aromatics, oxazoles, furoxanes, thiazoles, tetraaylmethanes, thiadiazoles, pyrazoles, metacyclophanes, acetylenes and the like. Specifically, materials described in, for example, JP-A No. 57-51781, JP-A No. 59-194393 and the like - herein enclosed by reference -, and known materials are mentioned.

Preferred hole transporting materials which may be contained in the liquid composition include polyvinylcarbazole and derivatives thereof, polysilane and derivatives thereof, polysiloxane derivatives having an aromatic amine on the side chain or the main chain, pyrazoline derivatives, arylamine derivatives, stilbene derivatives, triphenyldiamine derivatives, polyaniline and derivatives thereof, polythiophene and derivatives thereof, polypyrrole and derivatives thereof, poly(p-phenylenevinylene) and derivatives thereof, and poly(2,5-thienylenevinylene) and derivatives thereof.

Preferred electron transporting materials which may be contained in the liquid composition include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinoline derivatives; metal complexes of 8-hydroxyquinoline and derivatives thereof, polyquinoline and derivatives thereof, polyquinoxaline and derivatives thereof, and polyfluorene and derivatives thereof, fullerenes C₆₀ or C₇₀ and derivatives thereof.

Preferred stabilizers which may be contained in the liquid composition include phenol antioxidants and phosphorus antioxidants.

Preferred additives for adjusting viscosity and/or surface tension which may be contained in the liquid composition include a high molecular weight compound (thickening agent) and a poor solvent for increasing viscosity, a low molecular weight compound for decreasing viscosity, and a surfactant for lowering surface tension. The poor solvent means a solvent with which the weight of the polymer compound of the present invention dissolvable in 1 g of the solvent is 0.1 mg or less.

As the above-described high molecular weight compound, those not disturbing light adsorption and charge transportation may be permissible, and usually, those which are soluble in the solvent of the liquid composition are mentioned. As the high molecular weight compound, for example, polystyrene of high molecular weight and polymethyl methacylate of high molecular weight can be used. The above-described high molecular weight compound has a polystyrene-equivalent weight average molecular weight of preferably 500000 or more, more preferably 1000000 or more. A poor solvent can also be used as a thickening agent.

Preferred antioxidants which may be contained in the liquid composition, those not disturbing light adsorption and charge transportation may be permissible, and when the composition contains a solvent, usually, those which are soluble in the solvent are mentioned. As the antioxidant, phenol antioxidants and phosphorus antioxidants are exemplified. By use of the antioxidant, the preservation stability of the above-described polymer compound and solvent can be improved.

When the liquid composition of the present invention contains a hole transporting material, the amount of the hole transporting material in the liquid composition is usually 1 to 80 parts by weight, preferably 5 to 60 parts by weight when the weight of all components excluding the solvent is 100 parts by weight. When the liquid composition of the present invention contains an electron transporting material, the amount of the electron transporting material in the liquid composition is usually 1 to 80 parts by weight, preferably 5 to 60 parts by weight when the weight of all components excluding the solvent is 100 parts by weight.

In the case of film formation using this liquid composition in fabricating a photovoltaic device, it may be advantageous to only remove a solvent by drying after application of the liquid composition, and also in the case of mixing of a charge transporting material and a light adsorbing material, the same means can be applied, that is, this method is extremely advantageous for production. In drying, drying may be effected under heating at about 50 to 150°C, alternatively, drying may be carried out under reduced pressure of about 10⁻³ Pa.

As the film formation method using the liquid composition, application methods preferably a spin coat method, a casting method, a slot die coat method, a micro gravure coat method, a gravure coat method, a bar coat method, a roll coat method, a wire bar coat method, a dip coat method, a spray coat method, a screen printing method, a flexo printing method, an offset printing method, an inkjet print method and the like can be used.

The proportion of a solvent in the liquid composition is usually 1 wt% to 99.9 wt%, preferably 60 wt% to 99.9 wt%, further preferably 90 wt% to 99.8 wt% with respect to the total weight of the liquid composition. Though the viscosity of the liquid composition varies depending on a printing method, the viscosity at 25°C is preferably in the range of 0.5 to 500 mPa·s, and when a liquid composition passes through a discharge apparatus such as in an inkjet print method and the like, the viscosity at 25°C is preferably in the range of 0.5 to 20 mPa·s, for preventing clogging and flying curving in discharging.

As the solvent contained in the liquid composition, those capable of dissolving or dispersing components other than the solvent in the composition are preferable. Preferred solvents are chlorine-based solvents preferably selected from the group of chloroform, methylene chloride, 1,2-dichloroethane, 1,1,2-trichloroethane, chlorobenzene, o-dichlorobenzene and the like, ether solvents preferably tetrahydrofuran, dioxane and the like, aromatic hydrocarbon solvents preferably toluene, xylene, trimethylbenzene, mesitylene and the like, aliphatic hydrocarbon solvents preferably cyclohexane, methylcyclohexane, n-pentane, n-hexane, n-heptane, n-octane, n-nonane, n-decane and the like, ketone solvents preferably acetone, methyl ethyl ketone, cyclohexanone and the like, ester solvents preferably ethyl acetate, butyl acetate, methyl benzoate, ethyl-cellosolve acetate and the like, polyhydric alcohols preferably ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, 1,2-hexane diol and the like and derivatives thereof, alcohol solvents preferably methanol, ethanol, propanol, isopropanol, cyclohexanol and the like, sulfoxide solvents preferably dimethyl sulfoxide and the like, amide solvents such as N-methyl-2-pyrrolidone, N,N-dimethylformamide, and the like. These solvents may be used singly or in combination of two or more. Among the above-described solvents, one or more organic solvents having a structure containing at least one benzene ring and having a melting point of 0°C or lower and a boiling point of 100°C or higher are preferably contained from the standpoint of viscosity, film formability and the like.

Regarding the kind of the solvent, aromatic hydrocarbon solvents, aliphatic hydrocarbon solvents, ester solvents and ketone solvents are preferable from the standpoint of solubility of components other than the solvent in the liquid composition into the solvent, uniformity in film formation, viscosity property and the like, and more preferable are toluene, xylene, ethylbenzene, diethylbenzene, trimethylbenzene, mesitylene, n-propylbenzene, i-propylbenzene, n-butylbenzene, i-butylbenzene, s-butylbenzene, anisole, ethoxybenzene, 1-methylnaphthalene, cyclohexane, cyclohexanone, cyclohexylbenzene, bicyclohexyl, cyclohexenylcyclohexanone, n-heptylcyclohexane, n-hexylcyclohexane, methyl benzoate, 2-propylcyclohexanone, 2-heptanone, 3-heptanone, 4-heptanone, 2-octanone, 2-nonanone, 2-decanone, dicyclohexyl ketone and bicyclohexylmethyl benzoate, and particularly preferable are xylene, anisole, mesitylene, cyclohexylbenzene and bicyclohexylmethyl benzoate.

The number of the solvents to be contained in the liquid composition is preferably 2 or more, more preferably 2 to 3, and further preferably 2 from the standpoint of film formability and from the standpoint of device properties, and the like.

When two solvents are contained in the liquid composition, one of them may be solid at 25°C. From the standpoint of film formability, it is preferable that one solvent has a boiling point of 180°C or higher and another solvent has a boiling point of lower than 180°C, and it is more preferable that one solvent has a boiling point of 200°C or higher and another solvent has a boiling point of lower than 180°C.

When three solvents are contained in the liquid composition, one or two of them may be solid at 25°C. From the standpoint of film formability, it is preferable that at least one of three solvents has a boiling point of 180°C or higher and at least one solvent has a boiling point of 180°C or lower, and it is more preferable that at least one of three solvents has a boiling point of 200°C or higher and 300°C or lower and at least one solvent has a boiling point of 180°C or lower.

When two or more solvents are contained in the liquid composition, the content of a solvent having the highest boiling point is preferably 40 to 90 wt%, more preferably 50 to 90 wt%, and further preferably 65 to 85 wt% with respect to the weight of all solvents contained in the liquid composition, from the standpoint of viscosity and film formability.

The polymer compound of the present invention can be used as photovoltaic material, as a light emitting material, but also as a film material, an organic semiconductor material, an organic transistor material, an optical material, a solar battery material, or a conductive material by doping.

Preferably the polymer compound of the present invention is used in a photovoltaic conversion device even called photovoltaic device or solar cell.

A photovoltaic device according to the present invention can be used preferably for applications as a solar cell, solar battery, solar module, an optical sensor and the like. Here, a solar battery as a preferred embodiment of the photoelectric conversion devices will be explained.

In a preferred embodiment the polymer compound of the present invention is used as the material of a solar battery, particularly, as an organic semiconductor layer of a schottky barrier type device utilizing an interface between an organic semiconductor and a metal, or as an hybrid semiconductor layer of a p-n heterojunction type device utilizing an interface between an organic semiconductor and an inorganic semiconductor, or organic semiconductor layer of a p-n heterojunction type device utilizing an interface between tat least two organic semiconductors.

In a further preferred embodiment the polymer compound of the present invention is used as an electron donating polymer or an electron accepting polymer in a bulk hetero junction type device in which the donor-acceptor contact area is increased, or as an electron donating conjugated polymer (dispersion supporting body) in a solar battery using a high molecular weight-low molecular weight composite system, more preferred a bulk hetero junction type organic photoelectric conversion device in which a fullerene derivative is dispersed as an electron acceptor. If the polymer compound of the present invention is used in a solar battery, high conversion efficiency can be obtained.

With respect to the structure of the solar battery, in the case of, for example, a p-n heterojunction type device, it is advantageous that a p-type semiconductor layer is formed on an ohmic electrode, for example, on ITO, further, an n-type semiconductor layer is laminated, and an ohmic electrode is provided thereon.

The solar battery is usually formed on a supporting substrate. The supporting substrate is preferably one which does not disturb the property as an organic photoelectric conversion device, and more preferred glass substrates and flexible film substrates and plastic substrates are used.

The solar battery can be produced by known methods, for example, a method described in Synth. Met., 102, 982 (1999), and a method described in Science, 270, 1789 (1995).

The present invention is even directed to a process for the manufacture of polymer compounds of general formula (I), (II) or (III) characterized in that Suzuki or Stille polycondensation reaction is involved to link the monomers together thus forming a conjugated polymer.

The polymer compounds of general formula (I') are generally produced using Stille or Suzuki polycondensation reactions as shown in Scheme 1:

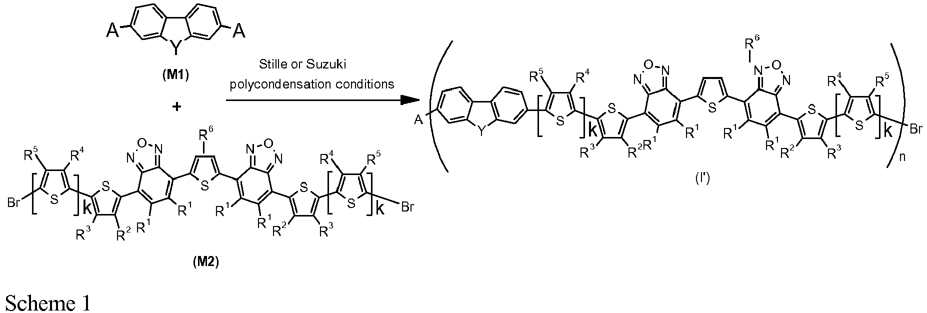

Scheme 1 shows the process to manufacture the polymer compound of general formula (I') with bromine as EG2 end group and A as end group EG1 wherein in the case of Stille polycondensation reaction substituent A is represented by stannyl residues (R)₃Sn-, preferably trialkylstannyl (Alkyl)₃Sn-, especially preferred trimethylstannyl Me₃Sn.

In the case of Suzuki polycondensation reaction substituent A is represented by boronic acid residue -B(OH)₂, boronic acid ester residue -B(OR)₂, preferably alkyl esters -B(OAlkyl)₂, especially preferred bronic acid ester residues selected from the list:

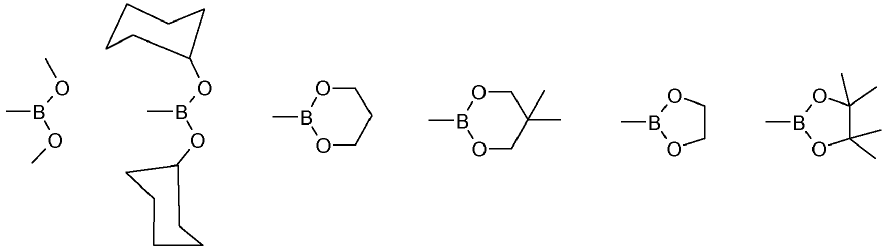

Alternatively, substituent A in the case of Suzuki polycondensation reaction can be represented by - BF₃K, -BF₃Na, -BF₃Rb or -BF₃Cs residues.

The present invention is even directed to a process for the manufacture of polymer compounds of general formula (I') characterized in that Suzuki or Stille polycondensation reaction is involved to link the monomers of formula (M1) and formula (M2) together thus forming a conjugated polymer according to the scheme 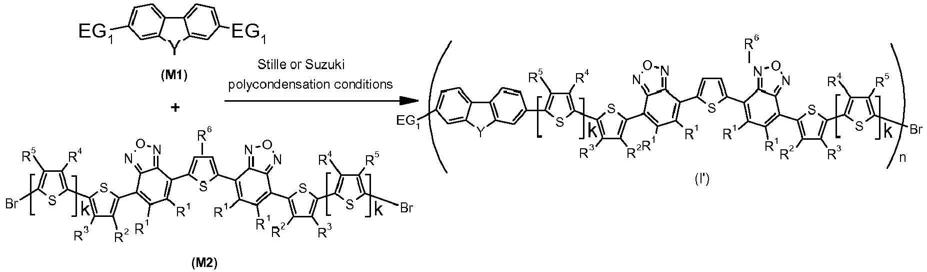 and the scheme shows the polymer compound of formula (I') with bromine as end group EG2 wherein in the case of a Stille polycondensation reaction end group EG1 is represented by stannyl residues (R)₃Sn-, preferably trialkylstannyl (Alkyl)₃Sn-, especially preferred trimethylstannyl Me₃Sn, and in the case of a Suzuki polycondensation reaction end group EG1 is represented by boronic acid group -B(OH)₂, boronic acid ester group -B(OR)₂, preferably alkyl esters -B(OAlkyl)₂, especially preferred bronic acid ester groups selected from the list 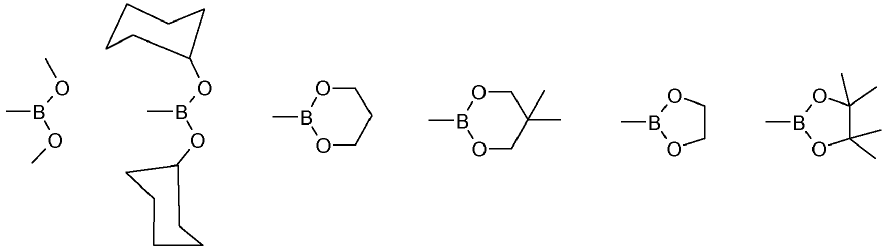 or alternatively, end group EG1 in the case of a Suzuki polycondensation reaction can be represented by -BF₃K, -BF₃Na, -BF₃Rb or -BF₃Cs groups and wherein Y, n, k, R¹, R², R³, R⁴, R⁵ or R⁶ have the same meanings as described in Claim 1..

The end groups of the polymer chain formed according to Scheme 1 can be further modified using a sequence of the reactions shown in Scheme 2:

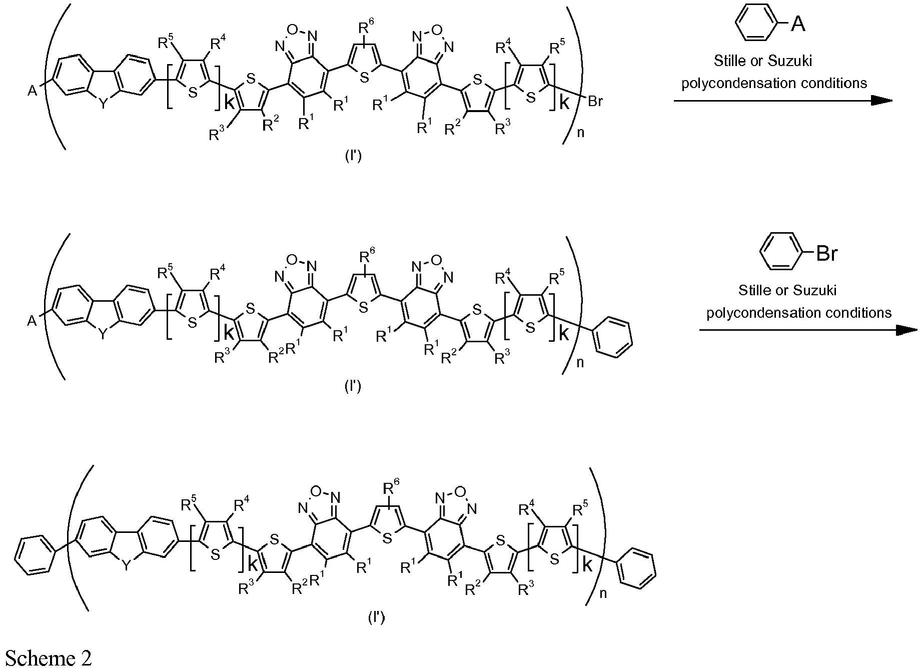

The conditions of Stille polycondensation reaction are known to a skilled experimenter. Generally, 0.0001-20 mole % of Pd(0) or Pd(II) catalyst is introduced to a solution of M1 and M2 taken into 1:1 molar ratio. Organic liquids which are not reactive towards M1, M2 or palladium catalyst can be used as solvents. Typically, toluene or xylenes or THF or DMF or their mixtures with other solvents are used to perform Stille polycondensation reactions. Toluene is a most preferred solvent. The reaction mixture preferably should be deaerated before initiation of the reaction. The reaction can be initiated using conventional heating or microwaves. Using microwaves is most preferred in some cases (see Microwave Methods in Organic Synthesis, M. Larhed, K. Olofsson, (Eds.), Topics in Current Chemistry, Vol. 266, 2006, XII, p. 103-144 for more details).

The reaction temperature might be set between 20 °C and 200 °C, preferably between 30 °C and 150 °C, more preferably between 50 °C and 130 °C, even more preferably preferably between 60 °C and 120 °C and the most preferably between 90 °C and 110 °C. The Stille polycondensation reaction is typically performed at normal (ambient, e.g. 760 mm Hg or 1.01325 bar) pressure. In some variations the reaction can be performed under reduced (e.g. 0.1 bar, 0.2 bar, 06 bar or 0.9 bar and etc.) or elevated pressure (e.g. 1.1 bar, 1.5 bar, 2 bar, 5 bar, 10 bar). The Stille polycondensation reaction might be carried out in sealed tubes or autoclave when reduced or elevated pressures are required. Practically important pressure range is between 0.01 and 100 bar, preferably between 0.1 and 10 bar.

The conditions of Suzuki polycondensation reaction are also known to a skilled experimenter. Generally, 0.0001-20 mole % of Pd(0) or Pd(II) catalyst is introduced to a solution of M1 and M2 taken into 1:1 molar ratio. Organic liquids which are not reactive towards M1, M2 or palladium catalyst can be used as solvents. Typically, toluene or xylenes or THF or DMF or their mixtures with other solvents are used to perform Suzuki polycondensation reactions. Optionally, an appropriate base and phase transfer catalyst can be introduced into the reaction. Preferred bases are aqueous or alcoholic solutions of alkali metal carbonates (e.g. K₂CO₃), alkali metal hydroxides (e.g. KOH, NaOH), organic bases such as tertiary amines (e.g. Et₃N, Hunig base) or tetraalkylammonium hydroxides (e.g. Et₄NOH, Bu₄NOH) and alkali metal salts such as K₃PO₄, CsF, Rb₃PO₄ and etc. More details can be found in the literature, e.g. Design and Synthesis of Conjugated Polymers, M. Leclerc and J. F. Morin Eds., Wiley InterScience (2010), p. 45-98 or A. Suzuki, Acc. Chem. Res. 1982, 15, 178-184.

The reaction temperature might be set between 20 °C and 200 °C, preferably between 30 °C and 150 °C, more preferably between 50 °C and 130 °C, even more preferably preferably between 60 °C and 120 °C and the most preferably between 90 °C and 110 °C. The Suzuki polycondensation reaction is typically performed at normal (ambient, e.g. 760 mm Hg or 1.01325 bar) pressure. In some variations the reaction can be performed under reduced (e.g. 0.1 bar, 0.2 bar, 06 bar or 0.9 bar and etc) or elevated pressure (e.g. 1.1 bar, 1.5 bar, 2 bar, 5 bar, 10 bar). The Suzuki polycondensation reaction might be carried out in sealed tubes or autoclave when reduced or elevated pressures are required. Practically important pressure range is between 0.01 and 100 bar, preferably between 0.1 and 10 bar.

Starting compounds of general formula (M1) are generally commercially available, for example 9,9-dioctylfluorene-2,7-diboronic acid (CAS 258865-48-4), 9,9-Dioctylfluorene-2,7-bis(trimethylborate) (CAS 317802-08-7), 9,9-Di(2-ethylhexyl)fluorene-2,7-diboronic acid bis(1,3-propanediol) ester solution (CAS 344782-49-6) and 9,9-Dihexylfluorene-2,7-bis(trimethyleneborate) (CAS 250597-29-6) are available from Sigma-Aldrich, 9-(9-Heptadecanyl)-9H-carbazole-2,7-diboronic acid bis(pinacol) ester (CAS 958261-51-3) can bye purchased from Debye Scientific Co., Limited and 9-(eicosan-11-yl)-2,7-bis(4,4,5,5-tetramethyl-1,3,2-dioxaborolan-2-yl)-9H-carbazole (1185885-88-4) can be obtained from Santai Labs, Inc. Starting compounds of general formula (M2) can be synthesized according to the chemical routes shown in Scheme 3 and Scheme 4 below.

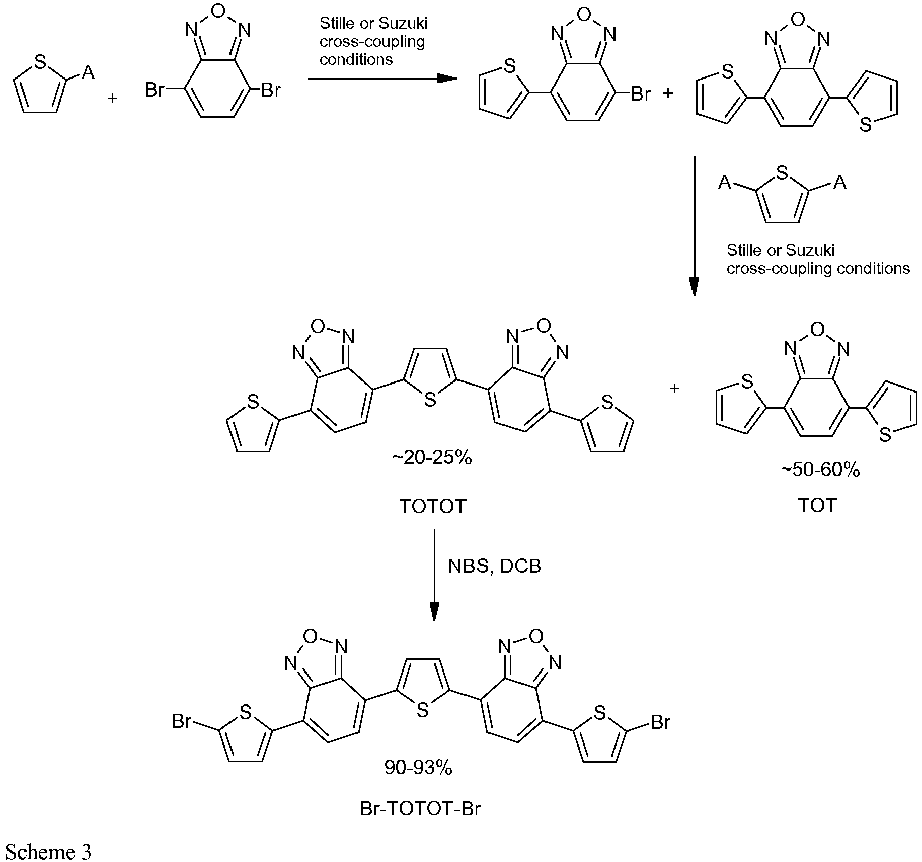

Meaning of substituent A in Scheme 3 is the same as described above for Scheme 1. Stille and Suzuki cross-coupling reaction conditions are known to a skilled experimenter and are very similar to the Stille and Suzuki polycondensation reaction conditions described above. The only difference in the Stille and Suzuki cross-coupling reaction conditions is a possibility of using non-stoichiometric reagent ratios. Preferably and as an example, 0.1 mole of 4,7-dibromo-1,2,3-benzooxadiazole (CAS 54286-63-4) was treated with 0.24 moles of tributyl(2-thienyl)tin (CAS 54663-78-4) on the first step and the formed product mixture was further quenched by addition of 0.04 mol of 2,5-bis(tributylstannyl)thiophene (CAS 145483-63-2) to produce a mixture of the desired TOTOT and TOT compounds. Small amounts (3-4%) of higher molecular weight compounds (e.g. TOTBTOT where B represents benzothiadiazole unit and T represents a thiophene unit) were also detected as byproducts in this reaction. The title TOTOT compound was isolated by pouring the reaction mixture into hexanes (800 mL), collection of the formed precipitate by filtration, washing it in a Soxhlet apparatus with acetone within 3-4 hrs and drying the residue in air. The yield of the dark purple crystalline powder of TOTOT was 25-30%. The TOT compound formed as a byproduct could be isolated by concentration of the hexane extract, precipitation of the residue in methanol (300 mL) an repeatable recrystallization from toluene-heptane mixtures. The purity of the prepared TOTOT samples estimated from HPLC and NMR data was between 95 and 97%.

Alternatively, the crude product obtained after precipitation in hexanes could be separated to produce pure TOT and TOTOT compounds by gradual sublimation in vacuum (10⁻² mbar) at 120 °C (TOT sublimes as orange crystalline film) and then 220-260 °C (TOTOT sublimes as dark purple crystals). Higher purity of TOTOT compound can be achieved by repeatable sublimation.

The synthesis of Br-TOTOT-Br was carried out by dissolving 1-2 mmol of TOTOT in 40-80 mL of warm 1,2-dichlorobenzene (55 °C), addition of an equimolecular amount of NBS and stirring the reaction mixture at 55 °C for 60 hrs. Following concentration of the reaction mixture to dryness and washing the residue with methanol, acetone and hexanes produced pure Br-TOTOT-Br in 95-98% yield.

The synthesis of (M2) from Br-TOTOT-Br can be accomplished according to the chemical route shown in Scheme 4.

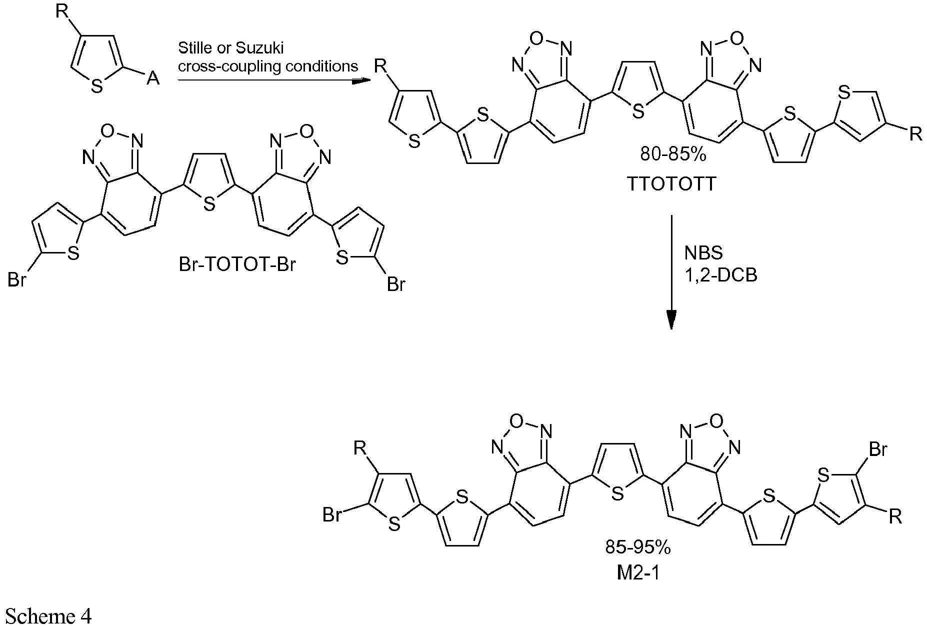

Meaning of the substituent A in Scheme 4 is the same as described above for Scheme 1. Stille and Suzuki cross-coupling reaction conditions are the same as described above for Scheme 3. Most preferably and as an example, Br-TOTOT-Br (1 eq.) was treated with (3-alkylthiophen-2-yl)boronic acid or ester (for example, 3-Hexyl-5-thiopheneboronic acid pinacol ester, CAS 883742-29-8, TCI UK) (3.5 eq.) or 4-(2-Ethylhexyl)-2-tributylstannylthiophene (CAS 886746-54-9) (4 eq.) in 1,2-dichlorobenzene at 35-70 °C within 12-48 hrs. The course of the reaction was controlled by HPLC. The resulting TTOTOTT could be purified by repeatable precipitation in methanol and/or by preparative GPC. The yield of TTOTOTT was 60-75%.

The bromination of TTOTOTT was carried out in 1,2-dichlorobzene using stoichiometric amount of NBS and by stirring the reagents at room temperature for 1 h (control of the reaction by HPLC). The yield of the title M2 was 88-98%.

Repeating the sequence of steps shown in Scheme 4 two times gives monomer M2-2 with extended conjugation length and improved solubility (Scheme 5):

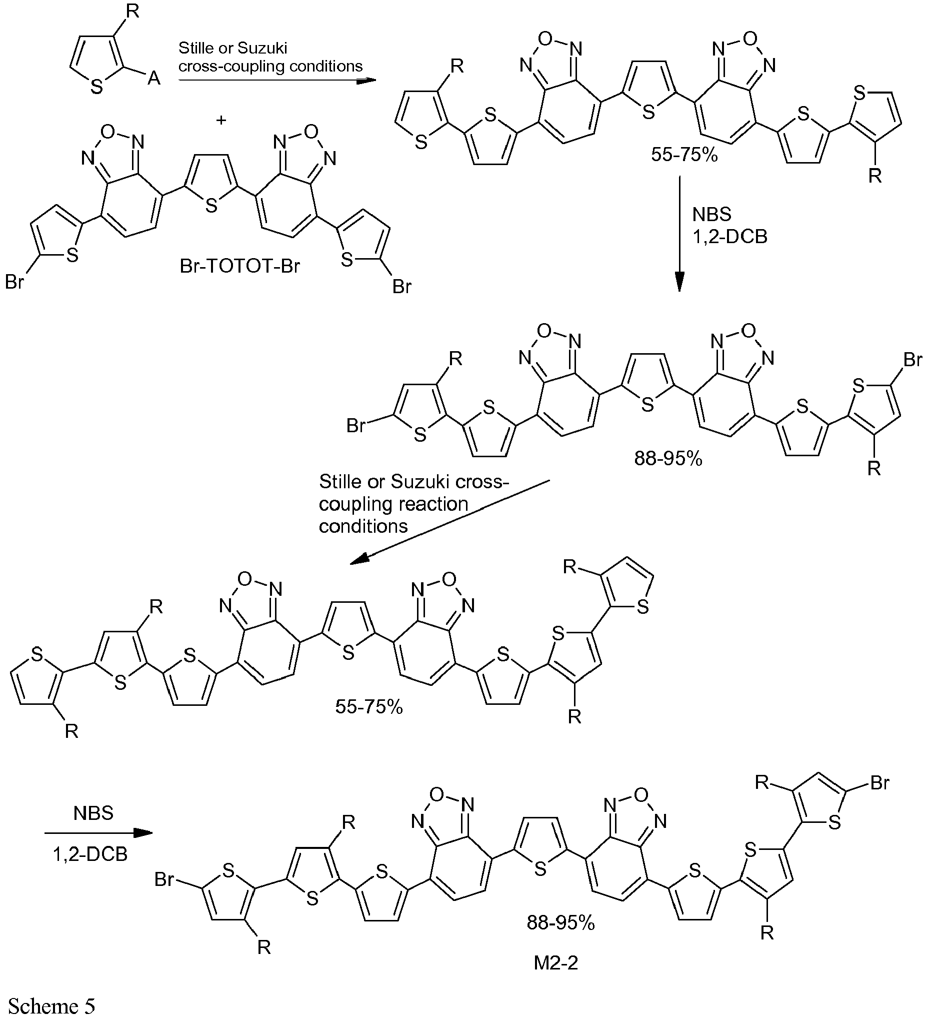

It will be understood that the specification and examples are illustrative but not limitative of the present invention and that other embodiments within the spirit and scope of the invention will suggest themselves to those skilled in the art.

### EXAMPLES

Examples will be shown below for illustrating the present invention further in detail, but the present invention is not limited to them.

The polystyrene-equivalent number average molecular weight and weight average molecular weight were measured by using size exclusion chromatography (SEC) (LC-20AD manufactured by Shimadzu Corporation).

### Analysis conditions

A polymer compound to be measured (1 mg) was dissolved in small amount of 1,2-dichlorbenzene (0.2-0.5 mL) and the resulting solution was diluted with 5-10 mL of tetrahydrofuran. The prepared solution was injected in an amount of 20 µL into SES (LC-20AD GPC instrument). Tetrahydrofuran was used as a mobile phase of SEC, the flow rate was 0.3 ml/min. Phenomenex 300x7.8 mm column filled with Phenogel particles (10⁴ Å) was used for analysis. The column was pre-calibrated against a series of polystyrene standards (1000-750000 g/mol, Fluka).

### Example 1 (Synthesis of compound P-1a - in the Scheme written as P1a)

The compound P-1a was synthesized by the following reaction:

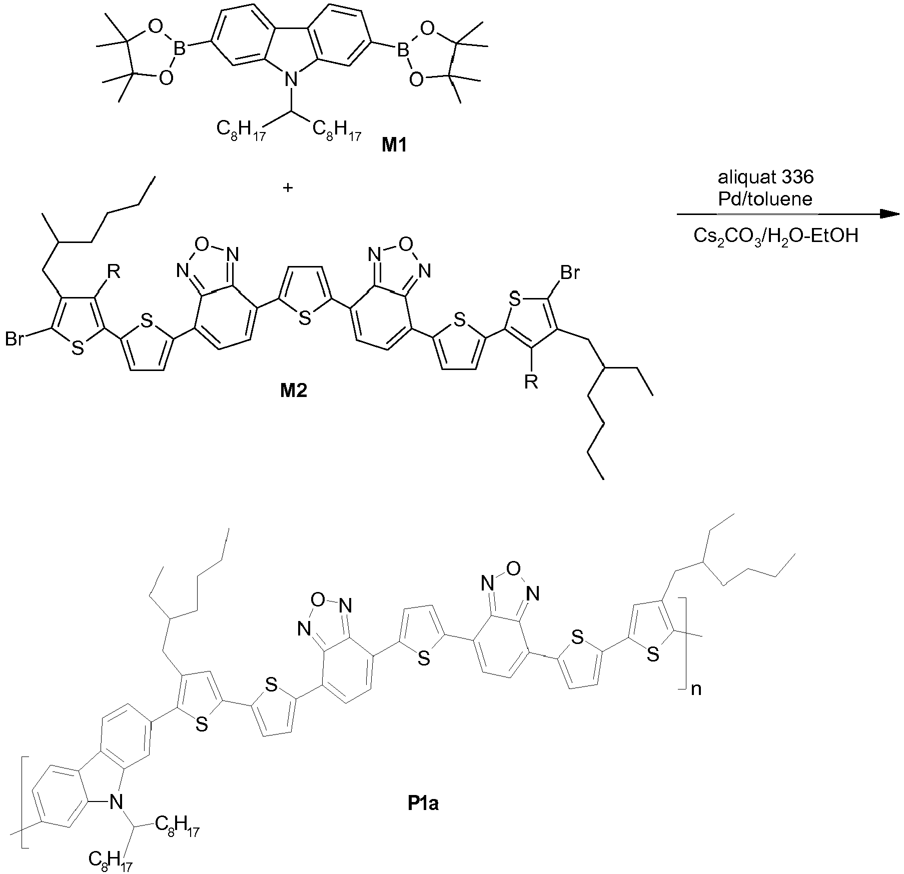

Monomers **M1** (657.6 mg, 1.0 mmol) and M2 (1031 mg, 1.0 mmol) were introduced into a 50 mL round-bottom three necked flask equiped with a thermometer and a reversed condenser. Toluene (25 mL), 2M aqueous solution of Cs₂CO₃ (2 mL), anhydrous ethanol (5 mL), aliquat 336 (1 drop, ca. 80 mg) and tetrakis(triphenylphosphine)palladium(0) (10 mg) were added in the listed here sequence. The reaction mixture was deairated using repeating cycles of freezing in liquid nitrogen, evacuation, filling with argon, and heating up to room temperature. The reaction flask with deairated mixture of reagents was immersed into an oil bath and heated at reflux for 3-6 hours. The molecular weight characteristics of the formed product were controlled every 30 min. The reaction was stopped when the weight average molecular weight M_{w} of the crude polymer formed in the reaction mixture showed no further increase with time. The mixture was cooled down to the room temperature, the polymer was extracted with 500 mL of toluene, the resulting solution was washed 3 times with deionised water (250 mL), dried and concentrated in vacuum (rotary evaporator) to 40 mL. Addition of 150 mL of methanol precipitated the crude polymer. Subsequent purification was achived using several additional dissolving/precipitation cycles. Finally, the precipitated polymer flakes were filtered out and dried in vacuum. The yield of the purified polymer **P-1a** varied between 50-65% depending on the applied number of dissolving/precipitation cycles. The prepared sample of **P-1a** showed the following molecular weight characteristics: M_{w}=24180 g/mol, Mₙ=13000 g/mol.

### Example 2 (Fabrication and evaluation of an organic thin film solar battery)

A photovoltaic cell, according to the present invention, was constructed in the following way. The patterned ITO-coated glass substrates (25 x 25 mm) were sonicated consecutively with acetone, isopropyl alcohol, and deionized water for 10 min. Subsequently, PEDOT:PSS (Clevios HTL Solar) was spin-coated on the ITO-coated glass substrates at 3000 rpm. The resulting films were dried in air at 180 °C for 15 min. Then the substrates were cooled down to 70 °C (or to the room temperature) and a photoactive blend comprising polymer **P1** was deposited on top. Photoactive blend solution was prepared as follows. Polymer **P-1a** (7 mg) and fullerene derivative [60]PCBM (14 mg) or [70]PCBE (ethyl ester of phenyl-C₇₁-butyric acid, 14 mg) were dissolved together in 1-chloronaphthalene (1-CN) in 1:2 weight ratio to achieve the total material concentration of 21 mg/ml. The blend solution was stirred for 52 hrs at 50 °C. The resulting polymer/fullerene solution was filtered through a paper filter, heated up to 50 °C_and spin-coated at 900-1100 rpm for 70 sec. on ITO/PEDOT:PSS substrates. The resulting gel-like coated films were dried in closed Petri dishes within next 12 hrs. The dried samples were subsequently annealed at 90°C for 10 min in an argon glovebox. The top electrode comprising 20 nm of Ca and 100 nm of Ag was deposited by thermal evaporation in the vacuum of 10⁻⁶ mbar.

The current-voltage (I-V) characteristics of the devices were obtained in dark and under the simulated 100 mW/cm² AM1.5 solar irradiation provided by a KHS Steuernagel solar simulator. The intensity of the illumination was checked every time before the measurements using a calibrated silicon diode with known spectral response. The photocurrent spectra were measured with a SRS 830 lock-in amplifier using the monochromated light from a 150W Xe lamp as excitation. Integration of the experimental IPCE spectra over real AM1.5 irradiation spectrum was used to check the short circuit current densities obtained from the I-V curves.

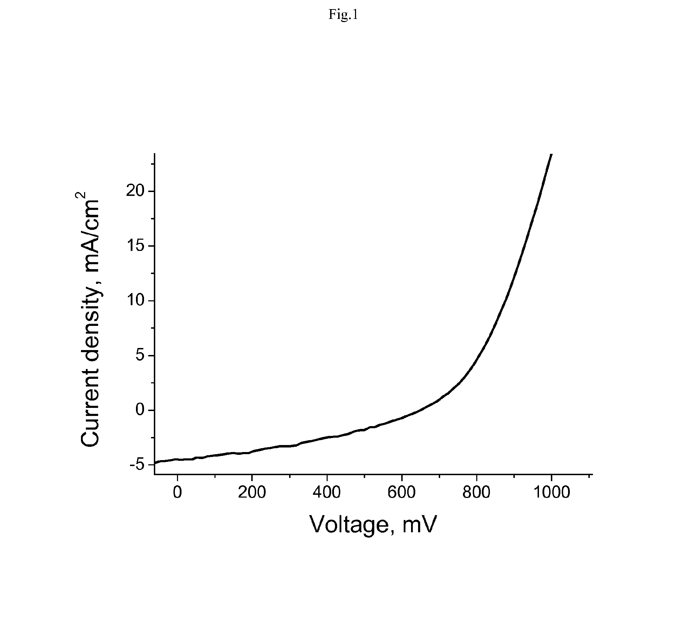

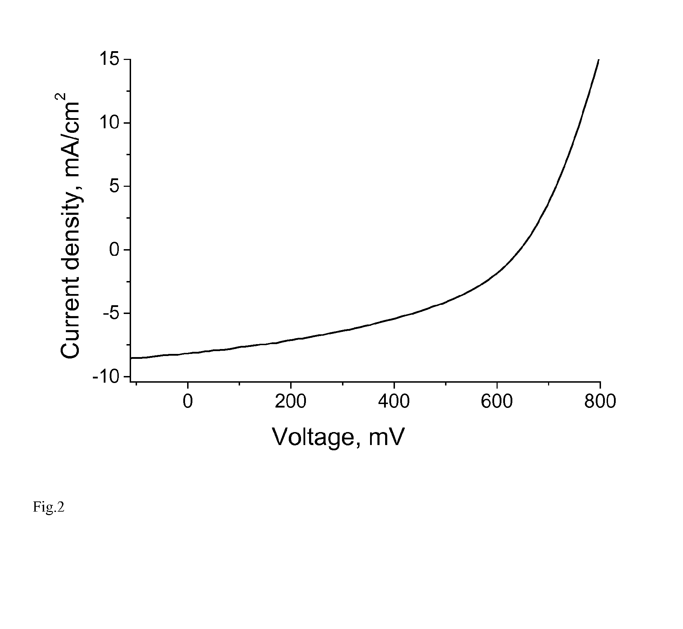

The parameters of the photovoltaic cells calculated from the current-voltage (I-V) curves are listed in Table 1. It is seen from the table that the best solar cells comprising polymer **P-1a** and [70]PCBE provided *J*_{SC} (short circuit current density) of 8.17 mA/cm², V_{OC} (open circuit voltage) of 0.644 V, FF (fill factor) of 42%, and photoelectric conversion efficiency (η) of 2.21 %. The I-V curves for the best devices are presented in Figs. 1 and 2.

**Table 1 Parameters of solar batteries comprising polymers P-1a and P-1b**

| **Photoactive layer composition** | ***V_{OC}*,** m V | ***J_{SC}, mA*/*cm²*** | ***FF**, %* | ***η*,** % |
|---|---|---|---|---|
| **P-1a**+[60]PCBM, 1:2 w/w | 650 | 4.55 | 35 | 1.05 |
| **P-1a**+[70]PCBE, 1:2 w/w | 644 | 8.17 | 42 | 2.21 |

Fig. 1. shows light-on I-V curve for a solar battery comprising polymer **P-1a** and [60]PCBM
Fig. 2. shows light-on I-V curve for a solar battery comprising polymer **P-1a** and [70]PCBE

## Claims

1. A polymer compound according to formula (I'): 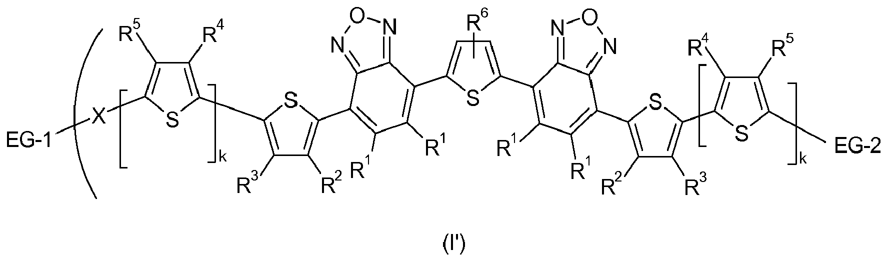 wherein in the repeating units R¹, R², R³, R⁴, R⁵, R⁶ are the same or mutually different and represent a hydrogen atom, a halogen atom, an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a heterocyclic group, preferably a mono-valent heterocyclic group, a heterocyclic group with at least one sulphur atom, an amino group, a substituted amino group, a silyl group, a substituted silyl group, an acyl group, an acyloxy group, an imine group, an amide group, an acid imide group, a carboxyl group, a substituted carboxyl group, a cyano group or a nitro group, and
X represents 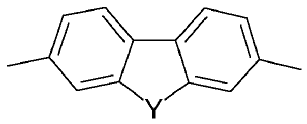 wherein Y = N-R⁷ or CR⁸R⁹,
k is a number of linearly linked thiophene units integrated in the repeating unit, preferably an integer from 0 to 3, n is the number of repeating units, preferably from 2 to 2000,
and R⁷, R⁸, R⁹ have the same meanings as R¹, R², R³, R⁴, R⁵ or R⁶,
EG-1 and EG-2 are the end groups of the polymer compound and independent from each other are represented by hydrogen, halogen, trialkylstannyl (-Sn(Alkyl)₃), boronic acid (-B(OH)₂), boronic ester (-B(OAlkyl)₂) or an aryl unit.

2. A polymer compound according to claim 1 **characterized in that** the end groups EG-1 and EG-2 of the polymer compound are represented by hydrogen, bromine or a phenyl unit.

3. A polymer compound according to claim 1 or 2 **characterized in that** it has repeating units of formula (I) 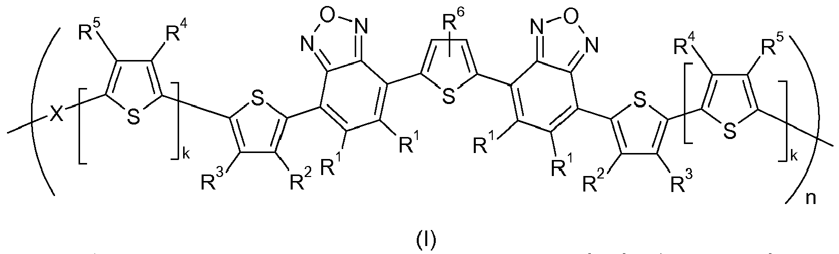 wherein R¹ represents a hydrogen atom or a fluorine atom and R², R³, R⁴, R⁵, and R⁶ are the same or different and each represents a hydrogen atom or a C₁-C₂₀ alkyl group, and k, n, X have the same meanings as in Claim 1.

4. A polymer compound according to claims 1 to 3 **characterized in that** the polymer compound is represented by formula (II') 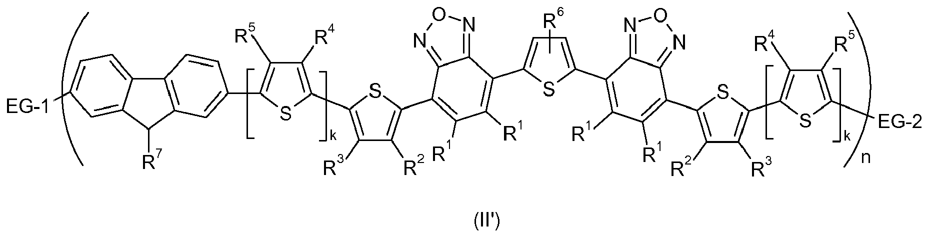 wherein integer k is a number of linearly linked thiophene units integrated in the repeating unit, preferably from 1 to 3, n is the number of repeating units, preferably from 2 to 2000, and
R¹, R², R³, R⁴, R⁵, R⁶ and R⁷ are the same or mutually different and represent a hydrogen atom, a halogen atom, an alkyl group, an alkoxy group, an alkylthio group, an aryl group, an aryloxy group, an arytlthio group, a heterocyclic group, preferably a mono-valent-heterocyclic group, a heterocyclic group with at least one sulphur atom, an amino group, a substituted amino group, a silyl group, a substituted silyl group, an acyl group, an acyloxy group, an imine group, an amide group, an acid imide group, a carboxyl group, a substituted carboxyl group, a cyano group or a nitro group,
EG-1 and EG-2 are the end groups of the polymer compound and independent from each other are represented by hydrogen, halogen, trialkylstannyl (-Sn(Alkyl)₃), boronic acid (-B(OH)₂), boronic ester (-B(OAlkyl)₂) or an aryl unit.

5. A polymer compound according to claims 1 to 3 **characterized in that** the polymer compound is represented by formula (III') 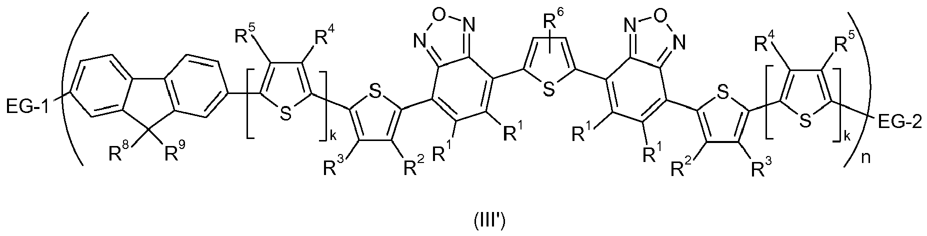 wherein k is a number of linearly linked thiophene units integrated in the repeating unit, preferably an integer from 0 to 3,
n is the number of repeating units, preferably from 2 to 2000, and
R¹, R², R³, R⁴, R⁵, R⁶, R⁸ and R⁹ are the same or mutually different and represent a hydrogen atom, a halogen atom, an alkyl group, an alkoxy group, an alkylthio group, an aryl group, an aryloxy group, an arylthio group, a heterocyclic group, preferably a mono-valent-heterocyclic group, a heterocyclic group with at least one sulphur atom, an amino group, a substituted amino group, a silyl group, a substituted silyl group, an acyl group, an acyloxy group, an imine group, an amide group, an acid imide group, a carboxyl group, a substituted carboxyl group, a cyano group or a nitro group,
EG-1 and EG-2 are the end groups of the polymer compound and independent from each other are represented by hydrogen, halogen, trialkylstannyl (-Sn(Alkyl)₃), boronic acid (-B(OH)₂), boronic ester (-B(OAlkyl)₂) or an aryl unit.

6. A polymer compound according to Claims 1 to 5 **characterized in that** R¹ represents a hydrogen atom or a fluorine atom and R², R³, R⁴, R⁵, R⁶, R⁷, R⁸ and R⁹ are the same or different and each represents a hydrogen atom or a C₁-C₂₀ alkyl group.

7. A polymer compound according to Claim 6 **characterized in that** R¹ represents a hydrogen atom and R², R³, R⁴, R⁵ and R⁶ are the same or different and each represents a hydrogen atom or a C₁-C₁₀ alkyl group, R⁷ represents a C₁-C₂₀ alkyl group, R⁸ and R⁹ are the same and each represents a C₁-C₁₀ alkyl group.

8. A polymer compound according to Claims 6 or 7 **characterized in that** R¹ represents a hydrogen atom, R², R³ and R⁴ are the same and each represents a hydrogen atom, R⁵ represents a C₁-C₁₀ alkyl group, R⁶ represents a hydrogen atom or a C₁-C₁₀ alkyl group, R⁷ represents a C₁-C₂₀ alkyl group, R⁸ and R⁹ are the same and each represents a C₁-C₁₀ alkyl group.

9. A polymer compound according to Claims 6 to 8 **characterized in that** R¹ represents a hydrogen atom, R², R³ and R⁵ are the same and each represents a hydrogen atom, R₄ represents a C₁-C₁₀ alkyl group, R⁶ represents a hydrogen atom or a C₁-C₁₀ alkyl group, R⁷ represents a C₁-C₂₀ alkyl group, R⁸ and R⁹ are the same and each represents a C₁-C₁₀ alkyl group.

10. A polymer compound according to Claims 6 to 9 **characterized in that** R¹ represents a hydrogen atom, R² and R⁴ are the same and each represents a C₁-C₁₀ alkyl group, R³ and R⁵ are the same and each represents a hydrogen atom, R⁶ represents a hydrogen atom or a C₁-C₁₀ alkyl group, R⁷ represents a C₁-C₂₀ alkyl group, R⁸ and R⁹ are the same and each represents a C₁-C₁₀ alkyl group.

11. A polymer compound according to Claims 6 to 10 **characterized in that** R¹ represents a hydrogen atom, R² and R⁴ are the same and each represents a hydrogen atom, R³ and R⁵ are the same and each represents a C₁-C₁₀ alkyl group, R⁶ represents a hydrogen atom or a C₁-C₁₀ alkyl group, R⁷ represents a C₆-C₂₀ alkyl group, R⁸ and R⁹ are the same and each represents a C₄-C₁₀ alkyl group.

12. A polymer compound according to Claims 6 to 11 **characterized in that** R¹ represents a hydrogen atom, R² and R⁴ are the same and each represents a hydrogen atom, R³ and R⁵ are the same and each represents a C₈ alkyl group, R⁶ represents a hydrogen atom, and R⁷ represents a C₁₇ alkyl group and to a polymer compound comprising repeating units of formula (II) wherein R¹ represents a hydrogen atom, R² and R⁴ are the same and each represents a C₈ alkyl group, R³ and R⁵ are the same and each represents a hydrogen atom, R⁶ represents a hydrogen atom, R⁷ represents a C₁₇ alkyl group, R⁸ and R⁹ are the same and each represents a C₈ alkyl group.

13. Use of the polymer compounds according to one of Claims 1 to 12 for the manufacture of photovoltaic conversion devices, preferably solar cells, solar batteries, solar modules or optical sensors.

14. A process for the manufacture of polymer compounds of general formula (I') **characterized in that** Suzuki or Stille polycondensation reaction is involved to link the monomers of formula (M1) and formula (M2) together thus forming a conjugated polymer according to the scheme 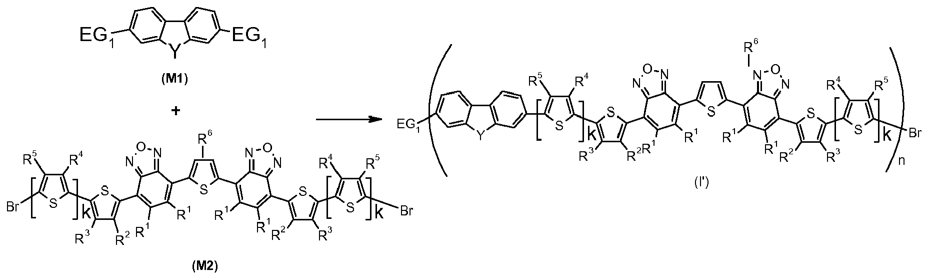 and the scheme shows the polymer compound of formula (I') with bromine as end group EG2 wherein in the case of a Stille polycondensation reaction end group EG1 is represented by stannyl residues (R)₃Sn-, preferably trialkylstannyl (Alkyl)₃Sn-, especially preferred trimethylstannyl Me₃Sn, and in the case of a Suzuki polycondensation reaction end group EG1 is represented by boronic acid group -B(OH)₂, boronic acid ester group -B(OR)₂, preferably alkyl esters -B(OAlkyl)₂, especially preferred bronic acid ester groups selected from the list 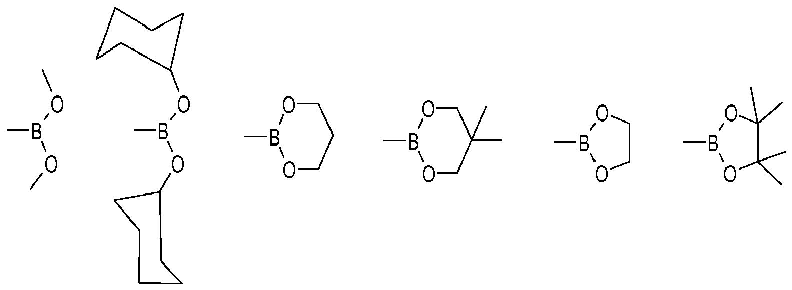 or alternatively, end group EG1 in the case of a Suzuki polycondensation reaction can be represented by -BF₃K, -BF₃Na, -BF₃Rb or -BF₃Cs groups and wherein Y, n, k, R¹, R², R³, R⁴, R⁵ or R⁶ have the same meanings as described in Claim 1..

15. A photovoltaic device, preferably a photoelectric conversion device, having an anode, a cathode, and an organic layer containing at least one of the polymer compounds according to Claims 1 to 12 disposed between the anode and the cathode.
